# EUROPEAN PATENT APPLICATION

(11) **EP 4 617 835 A1**
(43) Date of publication of application: **17.09.2025**
(21) Application number: 22938599.2
(22) Date of filing: 11.11.2022
(51) Int. Cl.: G06F 3/02

(54) **ELECTRONIC DEVICE**

(71) Applicant: Nintendo Co., Ltd., Kyoto-shi, Kyoto 601-8501 (JP)
(72) Inventor: OGASAWARA, Yoshiyasu, Kyoto-shi, Kyoto 601-8501 (JP); TSUCHIYA, Hitoshi, Kyoto-shi, Kyoto 601-8501 (JP); NIWA, Masato, Kyoto-shi, Kyoto 601-8501 (JP); FURUIKE, Hironori, Kyoto-shi, Kyoto 601-8501 (JP); SATO, Takahiro, Kyoto-shi, Kyoto 601-8501 (JP); TANIGUCHI, Nonoho, Kyoto-shi, Kyoto 601-8501 (JP)
(74) Representative: Bardehle Pagenberg Partnerschaft mbB Patentanwälte Rechtsanwälte
(86) International application number: PCT/JP2022/042089
(87) International publication number: WO 2023/203802

(57) **Abstract**

An electronic device includes a front surface, a rear surface, an upper surface, a lower surface, a first side surface, a second side surface, a first operation button, and a second operation button. A display is arranged at the front surface. The rear surface is located opposite to the front surface. The upper surface is contiguous to the front surface and the rear surface. The lower surface is located opposite to the upper surface. The first side surface is contiguous to each of the front surface, the rear surface, the upper surface, and the lower surface. The second side surface is located opposite to the first side surface. The upper surface is provided with a projecting portion. The first operation button is arranged at the projecting portion and provided closer to the first side surface relative to a center of the upper surface. The second operation button is arranged at the upper surface other than the projecting portion and provided closer to the first side surface relative to the first operation button.

## Description

### TECHNICAL FIELD

The present disclosure relates to an electronic device.

### BACKGROUND ART

Japanese Patent Laying-Open No. 2013-250807 (PTL 1) discloses a portable game console.

### CITATION LIST

### PATENT LITERATURE

PTL 1: Japanese Patent Laying-Open No. 2013-250807

### SUMMARY OF INVENTION

### TECHNICAL PROBLEM

In the portable game console described in PTL 1, a push button is provided at each of a left end side and a right end side of an upper surface. In provision of a plurality of buttons at the upper surface of an electronic device, however, there is a room for improvement in shape of the electronic device in a portion where the buttons are provided.

### SOLUTION TO PROBLEM

An electronic device according to the present disclosure includes a front surface, a rear surface, an upper surface, a lower surface, a first side surface, a second side surface, a first operation button, and a second operation button. A display is arranged at the front surface. The rear surface is located opposite to the front surface. The upper surface is contiguous to the front surface and the rear surface. The lower surface is located opposite to the upper surface. The first side surface is contiguous to each of the front surface, the rear surface, the upper surface, and the lower surface. The second side surface is located opposite to the first side surface. The upper surface is provided with a projecting portion. The first operation button is arranged at the projecting portion and provided closer to the first side surface relative to a center of the upper surface. The second operation button is arranged at the upper surface other than the projecting portion and provided closer to the first side surface relative to the first operation button.

According to the electronic device according to the present disclosure, the first operation button is arranged at the projecting portion and the second operation button is arranged at the upper surface other than the projecting portion. Therefore, even when a plurality of operation buttons are located at one side surface side of the upper surface, mix-up between the first operation button and the second operation button by the user can be less likely. Since two buttons can be operated simply by horizontally sliding a finger, the first operation button and the second operation button are more easily pushed. Furthermore, by providing the projecting portion at the upper surface, a finger does not have to greatly be bent, and hence the first operation button and the second operation button are more easily simultaneously pushed. By providing the projecting portion in the electronic device, the projecting portion can readily be caught with a hand when the electronic device is vertically held. Therefore, drop of the electronic device is less likely.

The electronic device according to the above may further include a third operation button and a fourth operation button. The third operation button may be arranged at the projecting portion and provided closer to the second side surface relative to the center of the upper surface. The fourth operation button may be arranged at the upper surface other than the projecting portion and provided closer to the second side surface relative to the third operation button. Four operation buttons can thus be arranged at the upper surface.

According to the electronic device according to the above, the projecting portion may include a first inclined portion located at a first side surface side and a second inclined portion located at a second side surface side. The first operation button may be arranged at the first inclined portion. The third operation button is arranged at the second inclined portion. Thus, while the first operation button and the second operation button are readily distinguished from each other, the first operation button and the second operation button are more easily pushed. Similarly, while the third operation button and the fourth operation button are readily distinguished from each other, the third operation button and the fourth operation button are more easily pushed.

According to the electronic device according to the above, the projecting portion may include a central portion located between the first inclined portion and the second inclined portion. A boundary portion between the central portion and the first inclined portion may be curved. A boundary portion between the central portion and the second inclined portion may be curved.

According to the electronic device according to the above, the second operation button may be arranged at a boundary portion between the upper surface and the first side surface. The fourth operation button may be arranged at a boundary portion between the upper surface and the second side surface. Thus, while a portion between a first j oint and a second j oint of a forefinger pushes the second operation button, the fourth operation button, the first operation button, the third operation button is more easily simultaneously pushed with a fingertip.

According to the electronic device according to the above, a boundary portion between the upper surface and the first side surface may be curved. A boundary portion between the upper surface and the second side surface may be curved.

According to the electronic device according to the above, in a direction from the lower surface toward the upper surface, a lowermost portion of the first operation button may be located above an uppermost portion of the second operation button and a lowermost portion of the third operation button may be located above an uppermost portion of the fourth operation button. Mix-up between the first operation button and the second operation button or between the third operation button and the fourth operation button is thus less likely in pushing the second operation button or the fourth operation button.

In an electronic device according to the present disclosure, a first device and a second device may be removably attachable to each other. The first device includes a first front surface, a first rear surface, a first upper surface, a first lower surface, a first right side surface, a first left side surface, a first operation button, and a second operation button. A first display is arranged at the first front surface. The first rear surface is located opposite to the first front surface. The first upper surface is contiguous to the first front surface and the first rear surface. The first lower surface is located opposite to the first upper surface. The first right side surface is contiguous to each of the first front surface, the first rear surface, the first upper surface, and the first lower surface. The first left side surface is located opposite to the first right side surface. The first upper surface is provided with a first projecting portion. The first operation button is arranged at the first projecting portion and provided closer to the first right side surface relative to a center of the first upper surface. The second operation button is arranged at the first upper surface other than the first projecting portion and provided closer to the first right side surface relative to the first operation button.

The second device includes a second front surface, a second rear surface, a second upper surface, a second lower surface, a second right side surface, a second left side surface, a third operation button, and a fourth operation button. A second display is arranged at the second front surface. The second rear surface is located opposite to the second front surface. The second upper surface is contiguous to the second front surface and the second rear surface. The second lower surface is located opposite to the second upper surface. The second right side surface is contiguous to each of the second front surface, the second rear surface, the second upper surface, and the second lower surface. The second left side surface is located opposite to the second right side surface. The second upper surface is provided with a second projecting portion. The third operation button is arranged at the second projecting portion and provided closer to the second right side surface relative to a center of the second upper surface. The fourth operation button is arranged at the second upper surface other than the second projecting portion and provided closer to the second right side surface relative to the second operation button. A first connection portion is provided at a first front surface side of the first projecting portion. A second connection portion connectable to the first connection portion is provided at a second rear surface side of the second projecting portion.

According to the electronic device according to the present disclosure, the first operation button is arranged at the first projecting portion and the second operation button is arranged at the first upper surface other than the first projecting portion. Therefore, even when a plurality of operation buttons are located at one side surface side of the first upper surface, mix-up between the first operation button and the second operation button by the user can be less likely. Since two buttons can be operated simply by horizontally sliding a finger, the first operation button and the second operation button are more easily pushed. Furthermore, by providing the first projecting portion at the first upper surface, a finger does not have to greatly be bent, and hence the first operation button and the second operation button are more easily simultaneously pushed. Similarly, even when a plurality of operation buttons are located at one side surface side of the second upper surface, mix-up between the third operation button and the fourth operation button by the user can be less likely. Since two buttons can be operated simply by horizontally sliding a finger, the third operation button and the fourth operation button are more easily pushed. Furthermore, by providing the second projecting portion at the second upper surface, a finger does not have to greatly be bent, and hence the third operation button and the fourth operation button are more easily simultaneously pushed. By providing the first projecting portion and the second projecting portion in the electronic device, the first projecting portion and the second projecting portion can readily be caught with a hand when the electronic device is held. Therefore, drop of the electronic device is less likely.

According to the electronic device according to the above, the second connection portion is connectable to the first connection portion in a first direction and a second direction opposite to the first direction. In a first connection state in which the second connection portion is connected to the first connection portion in the first direction, the second rear surface is arranged to cover the first display. In a second connection state in which the second connection portion is connected to the first connection portion in the second direction, the second rear surface is arranged not to cover the first display.

According to the electronic device according to the above, in the first connection state, mix-up among the first operation button, the second operation button, the third operation button, and the fourth operation button is less likely. In the second connection state, the first upper surface other than the first projecting portion and the second upper surface other than the second projecting portion are located at positions distant from each other, and hence wrong input to the second operation button and the fourth operation button is less likely.

According to the electronic device according to the above, the first device further includes a fifth operation button and a sixth operation button. The fifth operation button is arranged at the first projecting portion and provided closer to the first left side surface relative to the center of the first upper surface. The sixth operation button is arranged at the first upper surface other than the first projecting portion and provided closer to the first left side surface relative to the fifth operation button. The second device further includes a seventh operation button and an eighth operation button. The seventh operation button is arranged at the second projecting portion and provided closer to the second left side surface relative to the center of the second upper surface. The eighth operation button is arranged at the second upper surface other than the second projecting portion and provided closer to the second left side surface relative to the seventh operation button.

According to an electronic device 300 according to the above, in the first connection state, mix-up among the fifth operation button, the sixth operation button, the seventh operation button, and the eighth operation button is less likely. In the second connection state, the first upper surface other than the first projecting portion and the second upper surface other than the second projecting portion are located at positions distant from each other, and hence wrong input to the sixth operation button and the eighth operation button is less likely.

According to the electronic device according to the above, the first projecting portion includes a first right inclined portion located at a first right side surface side and a first left inclined portion located at a first left side surface side. The first right inclined portion is provided with the first operation button and the first left inclined portion is provided with the fifth operation button. The second projecting portion includes a second right inclined portion located at a second right side surface side and a second left inclined portion located at a second left side surface side. The second right inclined portion is provided with the third operation button and the second left inclined portion is provided with the seventh operation button.

According to the electronic device according to the above, the first projecting portion may include a first central portion located between the first right inclined portion and the first left inclined portion. A boundary portion between the first central portion and the first right inclined portion may be curved. A boundary portion between the first central portion and the first left inclined portion may be curved. The second projecting portion may include a second central portion located between the second right inclined portion and the second left inclined portion. A boundary portion between the second central portion and the second right inclined portion may be curved. A boundary portion between the second central portion and the second left inclined portion may be curved.

According to the electronic device according to the above, the second operation button may be arranged at a boundary portion between the first upper surface and the first right side surface. The sixth operation button may be arranged at a boundary portion between the first upper surface and the first left side surface. The fourth operation button may be arranged at a boundary portion between the second upper surface and the second right side surface. The eighth operation button may be arranged at a boundary portion between the second upper surface and the second left side surface. Thus, while a portion between a first j oint and a second j oint of a forefinger pushes the second operation button, the sixth operation button, the first operation button, the fifth operation button is more easily simultaneously pushed with a fingertip. Similarly, while a portion between a first joint and a second joint of a forefinger pushes the fourth operation button, the eighth operation button, the third operation button, the seventh operation button is more easily simultaneously pushed with a fingertip.

According to the electronic device according to the above, a boundary portion between the first upper surface and the first right side surface may be curved. A boundary portion between the first upper surface and the first left side surface may be curved. A boundary portion between the second upper surface and the second right side surface may be curved. A boundary portion between the second upper surface and the second left side surface may be curved.

According to the electronic device according to the above, in a direction from the first lower surface toward the first upper surface, a lowermost portion of the first operation button may be located above an uppermost portion of the second operation button and a lowermost portion of the fifth operation button may be located above an uppermost portion of the sixth operation button. In a direction from the second lower surface toward the second upper surface, a lowermost portion of the third operation button may be located above an uppermost portion of the fourth operation button and a lowermost portion of the seventh operation button may be located above an uppermost portion of the eighth operation button. Mix-up between the first operation button and the second operation button or between the fifth operation button and the sixth operation button is thus less likely in pushing the second operation button or the sixth operation button. Similarly, mix-up between the third operation button and the fourth operation button or between the seventh operation button and the eighth operation button is less likely in pushing the fourth operation button or the eighth operation button.

According to the electronic device according to the above, at a second front surface side of the second projecting portion, an input portion or a camera lens may be provided. In an example where the input portion is provided at the second front surface side of the second projecting portion, as compared with an example where the input portion is provided at the second upper surface, in operation of the operation button by a user, wrong input to the input portion can be suppressed. In an example where the camera lens is provided at the second front surface side of the second projecting portion, the camera lens can be arranged at the second front surface side while a large size of the second display is maintained.

### ADVANTAGEOUS EFFECTS OF INVENTION

According to the present disclosure, an electrical device with novel button arrangement can be provided.

### BRIEF DESCRIPTION OF DRAWINGS

Fig. 1 is a schematic front view showing a configuration of an electronic device according to a first embodiment.
Fig. 2 is a schematic bottom view showing the configuration of the electronic device according to the first embodiment.
Fig. 3 is a schematic cross-sectional view showing a configuration of a third operation button and a fourth operation button.
Fig. 4 is a schematic front view showing a configuration of an electronic device according to a first modification of the first embodiment.
Fig. 5 is a schematic front view showing a configuration of an electronic device according to a second modification of the first embodiment.
Fig. 6 is a schematic perspective view showing a configuration of an electronic device according to a second embodiment.
Fig. 7 is a schematic front view showing a configuration of a first device.
Fig. 8 is an enlarged schematic diagram of a region VIII in Fig. 7.
Fig. 9 is a schematic front view showing a configuration of a second device.
Fig. 10 is a schematic cross-sectional view along the line X-X in Fig. 9.
Fig. 11 is a partially enlarged view of a second rear surface of the second device.
Fig. 12 is a schematic front view showing a configuration of the electronic device in a first connection state.
Fig. 13 is a schematic cross-sectional view along the line XIII-XIII in Fig. 12.
Fig. 14 is a schematic diagram showing relation between a first connection portion and a second connection portion in the first connection state.
Fig. 15 is a schematic cross-sectional view along the line XV-XV in Fig. 12.
Fig. 16 is a schematic front view showing a configuration of the electronic device in a second connection state.
Fig. 17 is a schematic cross-sectional view along the line XVII-XVII in Fig. 16.
Fig. 18 is a schematic cross-sectional view showing a state in which the electronic device in the second connection state is unlocked.
Fig. 19 is a schematic diagram showing relation between the first connection portion and the second connection portion in the second connection state.
Fig. 20 is a schematic cross-sectional view showing positional relation between a first antenna and a second antenna in the first connection state.
Fig. 21 is a schematic cross-sectional view showing positional relation between the first antenna and the second antenna in the second connection state.
Fig. 22 is a schematic perspective view showing a configuration of the electronic device in the second connection state.
Fig. 23 is a partial schematic perspective view showing a configuration of an electronic device according to a third embodiment.
Fig. 24 is a schematic cross-sectional view along the line XXIV-XXIV in Fig. 23.

### DESCRIPTION OF EMBODIMENTS

An embodiment of the present disclosure will be described in detail with reference to the drawings. The same or corresponding elements in the drawings have the same reference characters allotted and description thereof will not be repeated.

### (First Embodiment)

A configuration of an electronic device 300 according to a first embodiment will initially be described.

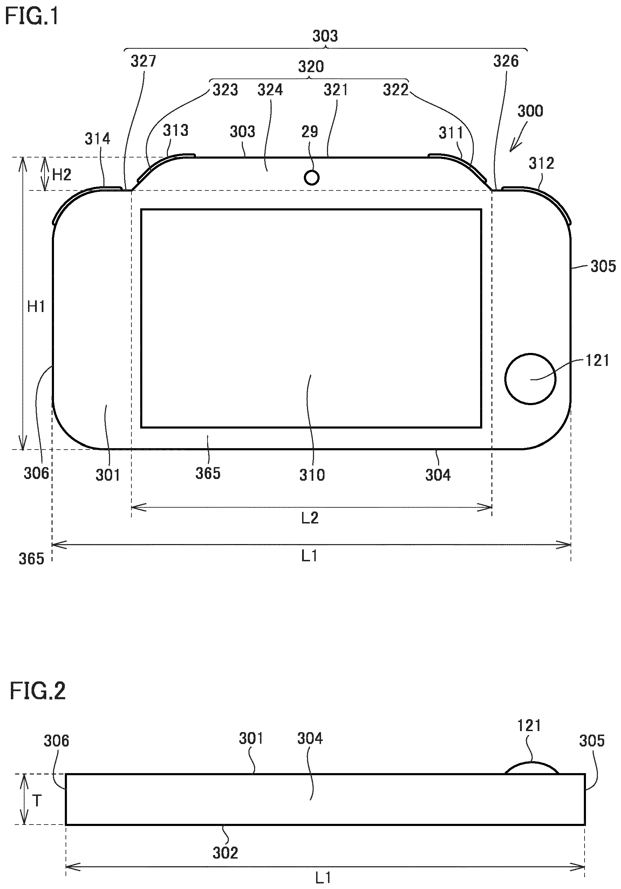

Fig. 1 is a schematic front view showing the configuration of electronic device 300 according to the first embodiment. Fig. 2 is a schematic bottom view showing the configuration of electronic device 300 according to the first embodiment. As shown in Figs. 1 and 2, electronic device 300 according to the first embodiment includes a third front surface 301, a third rear surface 302, a third upper surface 303, a third lower surface 304, a first side surface 305, and a second side surface 306. Third rear surface 302 is located opposite to third front surface 301. Third upper surface 303 is contiguous to each of third front surface 301, third rear surface 302, second side surface 306, and first side surface 305. Third lower surface 304 is located opposite to third upper surface 303. First side surface 305 is contiguous to each of third front surface 301, third rear surface 302, third upper surface 303, and third lower surface 304. Second side surface 306 is located opposite to first side surface 305. Second side surface 306 is contiguous to each of third front surface 301, third rear surface 302, third upper surface 303, and third lower surface 304.

As shown in Fig. 1, electronic device 300 further includes a third housing 365 and a third display 310. Third display 310 is arranged at third front surface 301. Third display 310 is attached to third housing 365.

Electronic device 300 shown in Fig. 1 is, for example, a game console, a smartphone, a tablet personal computer, a controller that can transmit an input signal to another electronic device, or the like. Electronic device 300 does not have to include third display 310.

As shown in Fig. 1, when third display 310 is viewed in a plan view, third housing 365 surrounds third display 310. Third display 310 being viewed in the plan view corresponds to electronic device 300 being viewed in a direction from third front surface 301 toward third rear surface 302. Third housing 365 includes a third projecting portion 320. Third projecting portion 320 extends in an outward direction of third display 310.

Third upper surface 303 includes a part of a fourth operation button 314, a third left upper surface portion 327, third projecting portion 320, a third right upper surface portion 326, and a part of a second operation button 312. Third projecting portion 320 is configured by connection of a third right inclined portion 322, a third left inclined portion 323, a third central portion 321, a third front surface portion 324 which is a part of third front surface 301, and a third rear surface portion which is a part of third rear surface 302. Third projecting portion 320 is distant from each of first side surface 305, second side surface 306, and third lower surface 304. Third projecting portion 320 may project only from around a portion intermediate between third front surface 301 and third rear surface 302 in third upper surface 303 and may be distant from each of third front surface 301 and third rear surface 302.

Third projecting portion 320 includes third right inclined portion 322, third left inclined portion 323, third central portion 321, and third front surface portion 324. Third right inclined portion 322 is located at a first side surface 305 side of third projecting portion 320. Third left inclined portion 323 is located at a second side surface 306 side of third projecting portion 320. Third central portion 321 is located between third right inclined portion 322 and third left inclined portion 323. Third central portion 321 is contiguous to each of third right inclined portion 322 and third left inclined portion 323. Third front surface portion 324 is contiguous to each of third right inclined portion 322, third left inclined portion 323, and third central portion 321. Third front surface portion 324 defines a part of third front surface 301. Third right inclined portion 322 is a portion inclined from third central portion 321 toward third right upper surface portion 326. Third left inclined portion 323 is a portion inclined from third central portion 321 toward third left upper surface portion 327.

As shown in Fig. 1, when third display 310 is viewed in the plan view, in a direction from third upper surface 303 toward third lower surface 304, a height of electronic device 300 and a height of third projecting portion 320 are defined as a first height H1 and a second height H2, respectively. Though a lower limit of second height H2 is not particularly limited, it may be, for example, not lower than 5% or not lower than 10% of first height H1. Though an upper limit of second height H2 is not particularly limited, it may be, for example, not higher than 30% or not higher than 20% of first height H1.

As shown in Fig. 1, when third display 310 is viewed in the plan view, in a direction from first side surface 305 toward second side surface 306, a length of electronic device 300 and a length of third projecting portion 320 are defined as a first length L1 and a second length L2, respectively. Though a lower limit of second length L2 is not particularly limited, it may be, for example, not lower than 50% or not lower than 60% of first length L1. Though an upper limit of second length L2 is not particularly limited, it may be, for example, not higher than 80% or not higher than 70% of first length L1.

First length L1 may be larger than first height H1. Second length L2 may be larger than second height H2. Though the lower limit of second length L2 is not particularly limited, it may be at least two times or at least three times as large as second height H2. Though the upper limit of second length L2 is not particularly limited, it may be not larger than twenty times or not larger than fifteen times as large as second height H2.

As shown in Fig. 1, when third display 310 is viewed in the plan view, third central portion 321 is substantially in parallel to third lower surface 304. Each of third right inclined portion 322 and third left inclined portion 323 is inclined with respect to third central portion 321. A boundary portion between third central portion 321 and third right inclined portion 322 may be curved as convexly projecting outward. Similarly, a boundary portion between third central portion 321 and third left inclined portion 323 may be curved as convexly projecting outward.

Third upper surface 303 includes third right upper surface portion 326 and third left upper surface portion 327. Third right upper surface portion 326 is located between third right inclined portion 322 and first side surface 305. Third right upper surface portion 326 is contiguous to each of third right inclined portion 322 and first side surface 305. A boundary portion between third right upper surface portion 326 and first side surface 305 may be curved as convexly projecting outward.

Similarly, third left upper surface portion 327 is located between third left inclined portion 323 and second side surface 306. Third left upper surface portion 327 is contiguous to each of third left inclined portion 323 and second side surface 306. A boundary portion between third left upper surface portion 327 and second side surface 306 may be curved as convexly projecting outward.

Electronic device 300 further includes a first operation button 311, second operation button 312, a third operation button 313, and fourth operation button 314. First operation button 311 is arranged at third projecting portion 320. Specifically, first operation button 311 is provided at a portion on the first side surface 305 side of third projecting portion 320. When third display 310 is viewed in the plan view, first operation button 311 is provided closer to first side surface 305 relative to a center of third upper surface 303. First operation button 311 is provided at third right inclined portion 322. First operation button 311 may be provided at a boundary portion between third central portion 321 and third right inclined portion 322.

Second operation button 312 is provided at third upper surface 303 other than third projecting portion 320. Specifically, second operation button 312 is provided at third right upper surface portion 326. Second operation button 312 may be provided at a boundary portion between third right upper surface portion 326 and first side surface 305. Second operation button 312 is provided closer to first side surface 305 relative to first operation button 311. In a direction from third lower surface 304 toward third upper surface 303, a lowermost portion of first operation button 311 may be located above an uppermost portion of second operation button 312.

Third operation button 313 is arranged at third projecting portion 320. Specifically, third operation button 313 is provided at a portion at the second side surface 306 side of third projecting portion 320. When third display 310 is viewed in the plan view, third operation button 313 is provided closer to second side surface 306 relative to the center of third upper surface 303. Third operation button 313 is provided at third left inclined portion 323. Third operation button 313 may be provided at a boundary portion between third central portion 321 and third left inclined portion 323.

Fourth operation button 314 is provided at third upper surface 303 other than third projecting portion 320. Specifically, fourth operation button 314 is provided at third left upper surface portion 327. Fourth operation button 314 may be provided at a boundary portion between third left upper surface portion 327 and second side surface 306. Fourth operation button 314 is provided closer to second side surface 306 relative to third operation button 313. In the direction from third lower surface 304 toward third upper surface 303, a lowermost portion of third operation button 313 may be located above an uppermost portion of fourth operation button 314.

As shown in Fig. 1, electronic device 300 may include a physical input portion 121. Input portion 121 is arranged at a first front surface 101 other than third front surface portion 324. Input portion 121 allows a stick operation or a button operation. When third display 310 is viewed in the plan view, input portion 121 may be located between third display 310 and first side surface 305 or between third display 310 and second side surface 306. Electronic device 300 does not have to include physical input portion 121. Third display 310 may be a touch panel.

As shown in Fig. 2, a thickness T of electronic device 300 in a direction from third front surface 301 toward third rear surface 302 is smaller than first length L1. Though a lower limit of thickness T is not particularly limited, it may be, for example, not lower than 5% or not lower than 10% of first length L1. Though an upper limit of thickness T is not particularly limited, it may be, for example, not higher than 50% or not higher than 30% of first length L1. Thickness T may be smaller than first height H1.

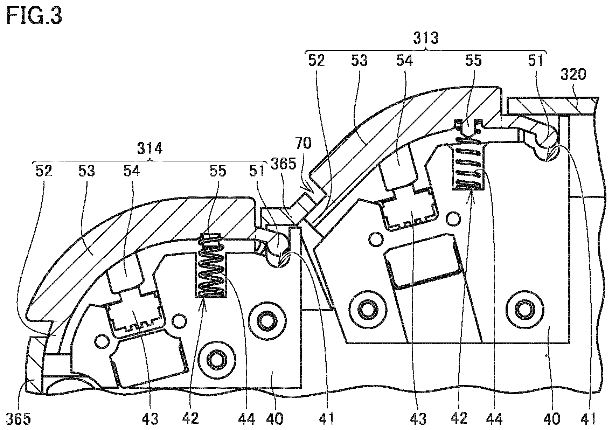

Fig. 3 is a schematic cross-sectional view showing a configuration of third operation button 313 and fourth operation button 314. The cross-section shown in Fig. 3 is in parallel to third front surface 301. Electronic device 300 includes a support member 40, a shaft receiving portion 41, an elastic body 44, a hole 42, and a detection portion 43. Shaft receiving portion 41 and hole 42 are recesses provided in support member 40. Elastic body 44 is, for example, a coil spring. Elastic body 44 is arranged in hole 42. Detection portion 43 is fixed to support member 40. Support member 40, shaft receiving portion 41, elastic body 44, hole 42, and detection portion 43 are arranged inside third housing 365.

Third operation button 313 includes a pressed portion 53, a movable shaft 51, a stopper portion 52, a second protruding portion 54, and a third protruding portion 55. Pressed portion 53 is a portion to be pushed by the user. Movable shaft 51 is arranged in shaft receiving portion 41. Movable shaft 51 is contiguous to pressed portion 53. Movable shaft 51 is in contact with an inner wall of third housing 365. Stopper portion 52 is contiguous to pressed portion 53. Stopper portion 52 is located opposite to movable shaft 51 with respect to pressed portion 53. Stopper portion 52 is in contact with the inner wall of third housing 365.

Second protruding portion 54 is contiguous to pressed portion 53. Second protruding portion 54 is arranged as being in contact with detection portion 43. Third protruding portion 55 is contiguous to pressed portion 53. Third protruding portion 55 is attached to elastic body 44. Third projecting portion 320 of third housing 365 is provided with a fifth opening portion 70. Pressed portion 53 is exposed to the outside of third housing 365 through fifth opening portion 70.

When the user pushes pressed portion 53 with his/her finger, second protruding portion 54 moves to the inside of third housing 365. As second protruding portion 54 applies a pressure to detection portion 43, input by the user is detected. As the user's finger moves away from pressed portion 53, third operation button 313 returns to an original position owing to repulsive force of elastic body 44. Each of movable shaft 51 and stopper portion 52 is in contact with the inner wall of third housing 365.

Though the configuration of third operation button 313 is described above, other operation buttons (specifically, first operation button 311, second operation button 312, and fourth operation button 314) are substantially the same in configuration to third operation button 313. Therefore, description of the configuration of other operation buttons will not be provided.

### (First Modification of First Embodiment)

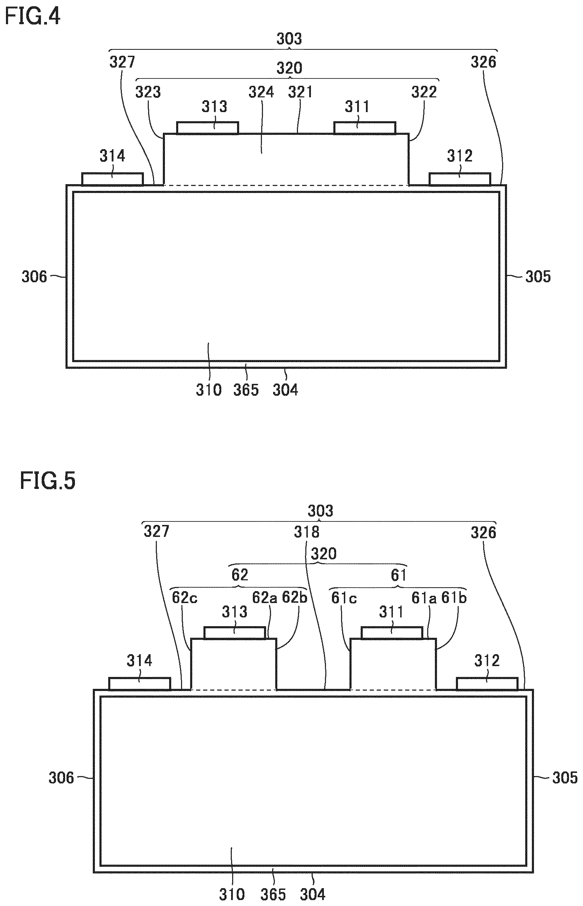

Fig. 4 is a schematic front view showing a configuration of electronic device 300 according to a first modification of the first embodiment. As shown in Fig. 4, third right inclined portion 322 may be substantially perpendicular to each of third central portion 321 and third right upper surface portion 326. Similarly, third left inclined portion 323 may be substantially perpendicular to each of third central portion 321 and third left upper surface portion 327.

First operation button 311 and third operation button 313 may be located at third central portion 321. First operation button 311 may be distant from third right inclined portion 322. Similarly, third operation button 313 may be distant from third left inclined portion 323. Second operation button 312 may be located at third right upper surface portion 326. Second operation button 312 may be distant from first side surface 305. Similarly, fourth operation button 314 may be located at third left upper surface portion 327. Fourth operation button 314 may be distant from second side surface 306. First operation button 311 may be arranged at third right inclined portion 322. Similarly, third operation button 313 may be arranged at third left inclined portion 323.

### (Second Modification of First Embodiment)

Fig. 5 is a schematic front view showing a configuration of electronic device 300 according to a second modification of the first embodiment. As shown in Fig. 5, third projecting portion 320 may include a first projecting region 61 and a second projecting region 62. First projecting region 61 is distant from second projecting region 62. Third upper surface 303 may include a third intermediate upper surface portion 318. Third intermediate upper surface portion 318 is located between third left upper surface portion 327 and third right upper surface portion 326. First projecting region 61 is located between third right upper surface portion 326 and third intermediate upper surface portion 318. Second projecting region 62 is located between third left upper surface portion 327 and third intermediate upper surface portion 318. First operation button 311 may be provided in first projecting region 61. Third operation button 313 may be provided in second projecting region 62.

First projecting region 61 includes a fourth central portion 61a, a fourth right inclined portion 61b, and a fourth left inclined portion 61c. Fourth central portion 61a is contiguous to each of fourth right inclined portion 61b and fourth left inclined portion 61c. Fourth right inclined portion 61b may be substantially perpendicular to each of fourth central portion 61a and third right upper surface portion 326. Similarly, fourth left inclined portion 61c may be substantially perpendicular to each of fourth central portion 61a and third intermediate upper surface portion 318.

Second projecting region 62 includes a fifth central portion 62a, a fifth right inclined portion 62b, and a fifth left inclined portion 62c. Fifth central portion 62a is contiguous to each of fifth right inclined portion 62b and fifth left inclined portion 62c. Fifth right inclined portion 62b may be substantially perpendicular to each of fifth central portion 62a and third intermediate upper surface portion 318. Similarly, fifth left inclined portion 62c may be substantially perpendicular to each of fifth central portion 62a and third left upper surface portion 327.

As shown in Fig. 5, first operation button 311 is provided at fourth central portion 61a of first projecting region 61. Third operation button 313 is provided at fifth central portion 62a of second projecting region 62. First operation button 311 may be arranged at fourth right inclined portion 61b. Similarly, third operation button 313 may be arranged at fifth left inclined portion 62c.

### (Second Embodiment)

A configuration of electronic device 300 according to a second embodiment will now be described.

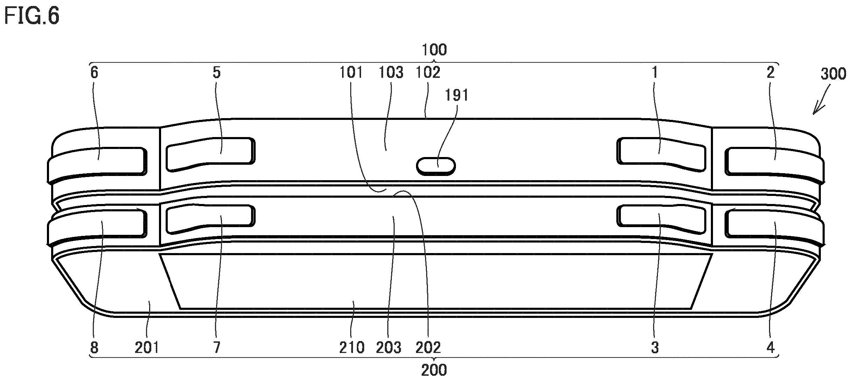

Fig. 6 is a schematic perspective view showing the configuration of electronic device 300 according to the second embodiment. As shown in Fig. 6, electronic device 300 according to the second embodiment includes a first device 100 and a second device 200. First device 100 and second device 200 are removably attachable to each other. Second device 200 is attachable to first device 100 and removable from first device 100.

As shown in Fig. 6, first device 100 includes a first front surface 101 and a first rear surface 102. First rear surface 102 is located opposite to first front surface 101. Second device 200 includes a second front surface 201, a second rear surface 202, and a second display 210. Second rear surface 202 is located opposite to second front surface 201. Second display 210 is arranged at second front surface 201. Second display 210 may be a touch panel on which a touch input can be provided.

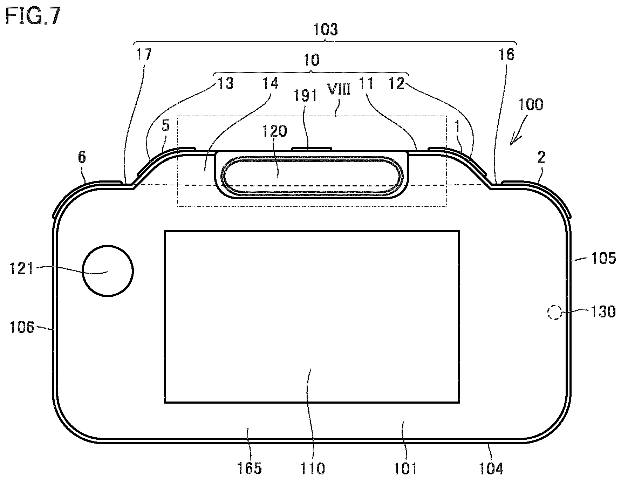

Fig. 7 is a schematic front view showing a configuration of first device 100. First device 100 includes a first upper surface 103, a first lower surface 104, a first right side surface 105, and a first left side surface 106. First upper surface 103 is contiguous to each of first front surface 101, first rear surface 102, first left side surface 106, and first right side surface 105. First lower surface 104 is located opposite to first upper surface 103. First right side surface 105 is contiguous to each of first front surface 101, first rear surface 102, first upper surface 103, and first lower surface 104. First left side surface 106 is located opposite to first right side surface 105. First left side surface 106 is contiguous to each of first front surface 101, first rear surface 102, first upper surface 103, and first lower surface 104.

As shown in Fig. 7, first device 100 may further include a first housing 165, a first display 110, a first connection portion 120, input portion 121, an unlocking button 191, and a Hall element 130. First display 110 is arranged at first front surface 101. First display 110 is attached to first housing 165.

As shown in Fig. 7, when first display 110 is viewed in the plan view, first housing 165 surrounds first display 110. First display 110 being viewed in the plan view corresponds to first device 100 being viewed in a direction from first front surface 101 toward first rear surface 102. First housing 165 includes a first projecting portion 10. First projecting portion 10 extends in an outward direction of first display 110. First connection portion 120 is provided at a front side of first projecting portion 10.

First projecting portion 10 is provided at first upper surface 103. First projecting portion 10 may define a part of first front surface 101. Similarly, first projecting portion 10 may define a part of first rear surface 102. First projecting portion 10 is distant from each of first right side surface 105, first left side surface 106, and first lower surface 104.

First projecting portion 10 includes a first right inclined portion 12, a first left inclined portion 13, a first central portion 11, and a first front surface portion 14. First right inclined portion 12 is located at a first right side surface 105 side of first projecting portion 10. First left inclined portion 13 is located at a first left side surface 106 side of first projecting portion 10. First central portion 11 is located between first right inclined portion 12 and first left inclined portion 13. First central portion 11 is contiguous to each of first right inclined portion 12 and first left inclined portion 13. First front surface portion 14 is contiguous to each of first right inclined portion 12, first left inclined portion 13, and first central portion 11. First front surface portion 14 defines a part of first front surface 101.

As shown in Fig. 7, when first display 110 is viewed in the plan view, first central portion 11 is substantially in parallel to first lower surface 104. Each of first right inclined portion 12 and first left inclined portion 13 is inclined with respect to first central portion 11. A boundary portion between first central portion 11 and first right inclined portion 12 may be curved as convexly projecting outward. Similarly, a boundary portion between first central portion 11 and first left inclined portion 13 may be curved as convexly projecting outward.

First upper surface 103 includes first right upper surface portion 16 and first left upper surface portion 17. First right upper surface portion 16 is located between first right inclined portion 12 and first right side surface 105. First right upper surface portion 16 is contiguous to each of first right inclined portion 12 and first right side surface 105. A boundary portion between first right upper surface portion 16 and first right side surface 105 may be curved as convexly projecting outward.

Similarly, first left upper surface portion 17 is located between first left inclined portion 13 and first left side surface 106. First left upper surface portion 17 is contiguous to each of first left inclined portion 13 and first left side surface 106. A boundary portion between first left upper surface portion 17 and first left side surface 106 may be curved as convexly projecting outward.

First device 100 further includes a first operation button 1, a second operation button 2, a fifth operation button 5, and a sixth operation button 6. First operation button 1 is arranged at first projecting portion 10. Specifically, first operation button 1 is provided at a portion of first projecting portion 10 at the first right side surface 105 side. When first display 110 is viewed in the plan view, first operation button 1 is provided closer to first right side surface 105 relative to a center of first upper surface 103. First operation button 1 is provided at first right inclined portion 12. First operation button 1 may be provided at a boundary portion between first central portion 11 and first right inclined portion 12.

Second operation button 2 is provided at first upper surface 103 other than first projecting portion 10. Specifically, second operation button 2 is provided at first right upper surface portion 16. Second operation button 2 may be provided at a boundary portion between first right upper surface portion 16 and first right side surface 105. Second operation button 2 is provided closer to first right side surface 105 relative to first operation button 1. In a direction from first lower surface 104 toward first upper surface 103, a lowermost portion of first operation button 1 may be located above an uppermost portion of second operation button 2.

Fifth operation button 5 is arranged at first projecting portion 10. Specifically, fifth operation button 5 is provided at a portion of first projecting portion 10 at the first left side surface 106 side. When first display 110 is viewed in the plan view, fifth operation button 5 is provided closer to first left side surface 106 relative to the center of first upper surface 103. Fifth operation button 5 is provided at first left inclined portion 13. Fifth operation button 5 may be provided at a boundary portion between first central portion 11 and first left inclined portion 13.

Sixth operation button 6 is provided at first upper surface 103 other than first projecting portion 10. Specifically, sixth operation button 6 is provided at first left upper surface portion 17. Sixth operation button 6 may be provided at a boundary portion between first left upper surface portion 17 and first left side surface 106. Sixth operation button 6 is provided closer to first left side surface 106 relative to fifth operation button 5. In the direction from first lower surface 104 toward first upper surface 103, a lowermost portion of fifth operation button 5 may be located above an uppermost portion of sixth operation button 6.

As shown in Fig. 7, when first display 110 is viewed in the plan view, first operation button 1 may be located closer to first right side surface 105 relative to first connection portion 120. Similarly, when first display 110 is viewed in the plan view, fifth operation button 5 may be located closer to first left side surface 106 relative to first connection portion 120.

First connection portion 120 is arranged at first front surface 101. At least a part of first connection portion 120 is located at first projecting portion 10. First connection portion 120 is attached to first housing 165. First connection portion 120 may project from a surface of first housing 165. When first display 110 is viewed in the plan view, first connection portion 120 is arranged between first upper surface 103 and first display 110.

As shown in Fig. 7, input portion 121 is arranged, for example, at first front surface 101. Input portion 121 can be operated as a stick or a button. Unlocking button 191 is arranged, for example, at first upper surface 103. Hall element 130 is arranged inside first housing 165. First device 100 does not have to include input portion 121.

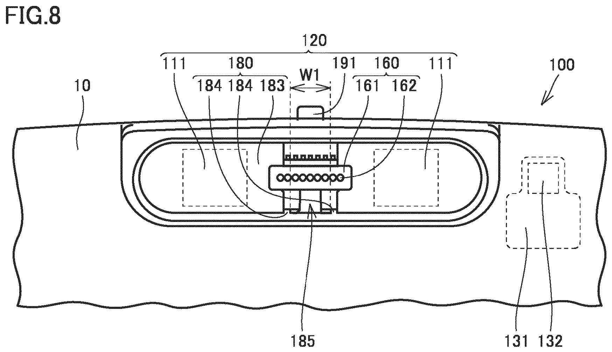

Fig. 8 is an enlarged schematic diagram of a region VIII in Fig. 7. As shown in Fig. 8, first connection portion 120 includes, for example, a first mechanical connection portion 180, a first electrical connection portion 160, and a first magnetic connection portion 111. First mechanical connection portion 180 includes a first main body portion 183 and a pair of first protruding portions 184. First main body portion 183 is attached to first housing 165. The pair of first protruding portions 184 is provided at first main body portion 183. First main body portion 183 is provided with a first opening portion 185.

First electrical connection portion 160 is exposed through first opening portion 185. First electrical connection portion 160 includes a first contact 162 and a first holding portion 161. First contact 162 is conductive. First holding portion 161 is insulating. First contact 162 is held by first holding portion 161. Though the number of first contacts 162 is not particularly limited, for example, nine first contacts are provided. When first display 110 is viewed in the plan view, first contacts 162 are arranged along a line. One of first contacts 162 is, for example, a terminal for electric power supply.

First magnetic connection portion 111 is configured, for example, with a pair of magnets. First magnetic connection portion 111 is located between first main body portion 183 and first rear surface 102. First magnetic connection portion 111 is arranged inside first device 100. As shown in Fig. 8, when first front surface 101 is viewed in the plan view, first electrical connection portion 160 is located as lying between the pair of magnets. In the present embodiment, when first front surface 101 is viewed in the plan view, first electrical connection portion 160 is located as lying between the pair of magnets in a longitudinal direction of first display 110 of first device 100.

First device 100 includes a first substrate 131 and a first antenna 132. Each of first substrate 131 and first antenna 132 is arranged inside first device 100. More particularly, each of first substrate 131 and first antenna 132 is arranged inside first housing 165. First antenna 132 is provided at first substrate 131.

The number of first antennas 132 is not particularly limited. The number of first antennas 132 is set, for example, to one or at least two. In electronic device 300 according to the present embodiment, a single first antenna 132 is provided. First antenna 132 is, for example, a first antenna portion 132. When first front surface 101 is viewed in the plan view, first antenna portion 132 may be arranged at a position adjacent to first connection portion 120. First antenna portion 132 is arranged, for example, between first connection portion 120 and first right side surface 105.

As shown in Fig. 8, when first front surface 101 is viewed in the plan view, first antenna 132 may be located on an outer side of first connection portion 120. From another point of view, when first front surface 101 is viewed in the plan view, first antenna 132 may be arranged at a position not superimposed on first main body portion 183. For example, resin is employed as a material for first housing 165. Though the material for first main body portion 183 is not particularly limited, for example, metal may be adopted. First antenna 132 may be arranged such that first main body portion 183 does not cut off electromagnetic field.

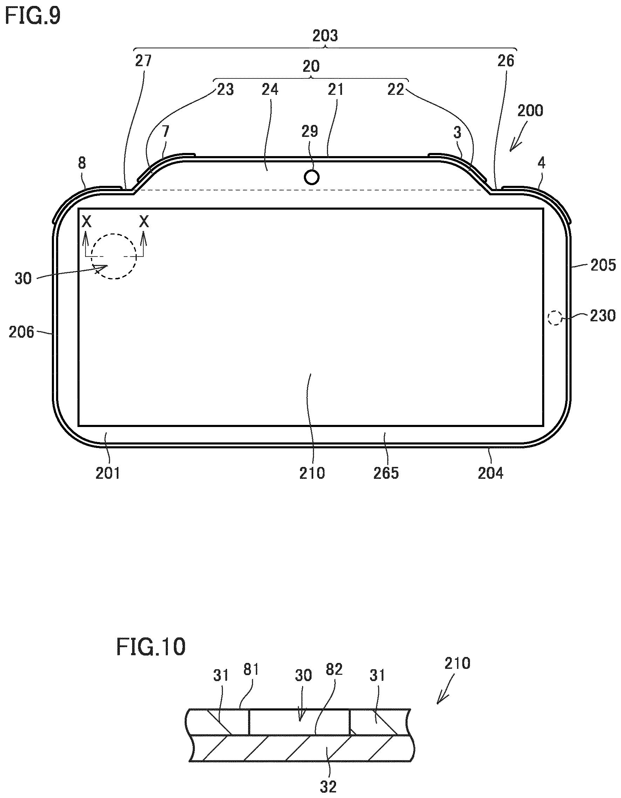

Fig. 9 is a schematic front view showing a configuration of second device 200. As shown in Fig. 9, second device 200 further includes a second upper surface 203, a second lower surface 204, a second right side surface 205, and a second left side surface 206. Second upper surface 203 is contiguous to second front surface 201 and second rear surface 202. Second lower surface 204 is located opposite to second upper surface 203. Second right side surface 205 is contiguous to each of second front surface 201, second rear surface 202, second upper surface 203, and second lower surface 204. Second left side surface 206 is located opposite to second right side surface 205. Second left side surface 206 is contiguous to each of second front surface 201, second rear surface 202, second upper surface 203, and second lower surface 204.

As shown in Fig. 9, second device 200 includes a second housing 265 and a magnet portion 230. Second display 210 is attached to second housing 265. Magnet portion 230 is arranged inside second housing 265. As shown in Fig. 9, when second display 210 is viewed in the plan view, magnet portion 230 may be located, for example, between second display 210 and second right side surface 205. Second display 210 being viewed in the plan view corresponds to second device 200 being viewed in a direction from second front surface 201 toward second rear surface 202.

As shown in Fig. 9, when second display 210 is viewed in the plan view, second housing 265 surrounds second display 210. Second housing 265 includes a second projecting portion 20. Second projecting portion 20 extends in the outward direction of second display 210. Second connection portion 220 is provided at a rear side of second projecting portion 20.

Second projecting portion 20 is provided at second upper surface 203. Second projecting portion 20 may define a part of second front surface 201. Similarly, second projecting portion 20 may define a part of second rear surface 202. Second projecting portion 20 is distant from each of second right side surface 205, second left side surface 206, and second lower surface 204.

Second projecting portion 20 includes a second right inclined portion 22, a second left inclined portion 23, a second central portion 21, and a second front surface portion 24. Second right inclined portion 22 is located at a second right side surface 205 side of second projecting portion 20. Second left inclined portion 23 is located at a second left side surface 206 side of second projecting portion 20. Second central portion 21 is located between second right inclined portion 22 and second left inclined portion 23. Second central portion 21 is contiguous to each of second right inclined portion 22 and second left inclined portion 23. Second front surface portion 24 is contiguous to each of second right inclined portion 22, second left inclined portion 23, and second central portion 21. Second front surface portion 24 defines a part of second front surface 201.

As shown in Fig. 9, when second display 210 is viewed in the plan view, second central portion 21 is substantially in parallel to second lower surface 204. Each of second right inclined portion 22 and second left inclined portion 23 is inclined with respect to second central portion 21. A boundary portion between second central portion 21 and second right inclined portion 22 may be curved as convexly projecting outward. Similarly, a boundary portion between second central portion 21 and second left inclined portion 23 may be curved as convexly projecting outward.

Second upper surface 203 includes a second right upper surface portion 26 and a second left upper surface portion 27. Second right upper surface portion 26 is located between second right inclined portion 22 and second right side surface 205. Second right upper surface portion 26 is contiguous to each of second right inclined portion 22 and second right side surface 205. A boundary portion between second right upper surface portion 26 and second right side surface 205 may be curved as convexly projecting outward.

Similarly, second left upper surface portion 27 is located between second left inclined portion 23 and second left side surface 206. Second left upper surface portion 27 is contiguous to each of second left inclined portion 23 and second left side surface 206. A boundary portion between second left upper surface portion 27 and second left side surface 206 may be curved as convexly projecting outward.

Second device 200 further includes a third operation button 3, a fourth operation button 4, a seventh operation button 7, and an eighth operation button 8. Third operation button 3 is arranged at second projecting portion 20. Specifically, third operation button 3 is provided at a portion of second projecting portion 20 at a second right side surface 205 side. When second display 210 is viewed in the plan view, third operation button 3 is provided closer to second right side surface 205 relative to a center of second upper surface 203. Third operation button 3 is provided at second right inclined portion 22. Third operation button 3 may be provided at a boundary portion between second central portion 21 and second right inclined portion 22.

Fourth operation button 4 is provided at second upper surface 203 other than second projecting portion 20. Specifically, fourth operation button 4 is provided at second right upper surface portion 26. Fourth operation button 4 may be provided at a boundary portion between second right upper surface portion 26 and second right side surface 205. Fourth operation button 4 is provided closer to second right side surface 205 relative to third operation button 3. In a direction from second lower surface 204 toward second upper surface 203, a lowermost portion of third operation button 3 may be located above an uppermost portion of fourth operation button 4.

Seventh operation button 7 is arranged at second projecting portion 20. Specifically, seventh operation button 7 is provided at a portion of second projecting portion 20 at the second left side surface 206 side. When second display 210 is viewed in the plan view, seventh operation button 7 is provided closer to second left side surface 206 relative to the center of second upper surface 203. Seventh operation button 7 is provided at second left inclined portion 23. Seventh operation button 7 may be provided at a boundary portion between second central portion 21 and second left inclined portion 23.

Eighth operation button 8 is provided at second upper surface 203 other than second projecting portion 20. Specifically, eighth operation button 8 is provided at second left upper surface portion 27. Eighth operation button 8 may be provided at a boundary portion between second left upper surface portion 27 and second left side surface 206. Eighth operation button 8 is provided closer to second left side surface 206 relative to seventh operation button 7. In the direction from second lower surface 204 toward second upper surface 203, a lowermost portion of seventh operation button 7 may be located above an uppermost portion of eighth operation button 8.

Each of first operation button 1, second operation button 2, third operation button 3, fourth operation button 4, fifth operation button 5, sixth operation button 6, seventh operation button 7, and eighth operation button 8 is substantially the same in configuration to third operation button 313 described with reference to Fig. 3. Therefore, description of the configuration of these operation buttons will not be provided.

As shown in Fig. 9, a front surface (second front surface portion 24) of second projecting portion 20 may be provided with a functional component 29. Functional component 29 may be, for example, a camera lens or an input portion. Second front surface 201 other than second projecting portion 20 may be provided with an operation portion (not shown). For example, second front surface 201 other than second projecting portion 20 may be provided with a physical stick. According to such a configuration, a space at the front surface (second front surface portion 24) of second projecting portion 20 can effectively be made use of.

Fig. 10 is a schematic cross-sectional view along the line X-X in Fig. 9. As shown in Fig. 10, second display 210 includes a touch panel 32 and a touch panel cover 31. Touch panel 32 is a panel on which a touch operation can be performed. Touch panel 32 performs a function to detect touch. Touch panel cover 31 covers touch panel 32. Touch panel cover 31 can receive an input operation to touch panel 32. Touch panel cover 31 itself does not perform a function to detect touch. When the user touches touch panel cover 31, the input operation to touch panel 32 therethrough can be performed.

Second display 210 includes a first tactile feel presentation portion 81 and a second tactile feel presentation portion 82. First tactile feel presentation portion 81 is implemented, for example, by touch panel cover 31. Touch panel cover 31 is provided with an opening 30. Second tactile feel presentation portion 82 is, for example, a portion where touch panel 32 is exposed through opening 30. Second tactile feel presentation portion 82 is a part of touch panel 32. Second tactile feel presentation portion 82 may be used as a virtual button or a virtual stick.

Second tactile feel presentation portion 82 may be a part of touch panel cover 31. In this case, second tactile feel presentation portion 82 may be different from first tactile feel presentation portion 81 in sense of touch. Second tactile feel presentation portion 82 may be a portion of a surface of touch panel cover 31 that is roughened. In this case, first tactile feel presentation portion 81 is a portion of the surface of touch panel cover 31 that is not roughened. Second tactile feel presentation portion 82 may be a portion where vibration is generated as the user touches the same. In this case, first tactile feel presentation portion 81 is a portion where vibration is not generated even when the user touches the same.

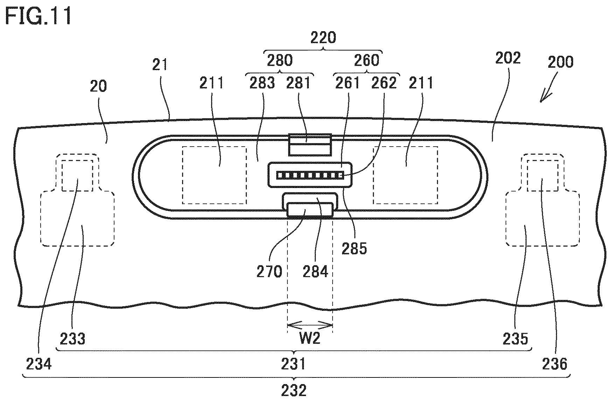

Fig. 11 is a partially enlarged view of second rear surface 202 of second device 200. As shown in Fig. 11, second device 200 includes a second connection portion 220. Second connection portion 220 is arranged at second rear surface 202. Second connection portion 220 includes, for example, a second mechanical connection portion 280, a second electrical connection portion 260, and a second magnetic connection portion 211. Second mechanical connection portion 280 includes a second main body portion 283, a fixed hook 281, and a movable hook 270. Second main body portion 283 is attached to second housing 265. Fixed hook 281 is fixed to second main body portion 283. Movable hook 270 is attached to second main body portion 283 as being movable.

Second main body portion 283 is provided with a second opening portion 285 and a third opening portion 284. Movable hook 270 is exposed through third opening portion 284. Movable hook 270 is located opposite to fixed hook 281. When second rear surface 202 is viewed in the plan view, second electrical connection portion 260 is located between movable hook 270 and fixed hook 281. Second electrical connection portion 260 is exposed through second opening portion 285. When second rear surface 202 is viewed in the plan view, fixed hook 281 is located between second central portion 21 and movable hook 270.

Second electrical connection portion 260 includes a second contact 262 and a second holding portion 261. Second contact 262 is conductive. Second holding portion 261 is insulating. Second contact 262 is held by second holding portion 261. Though the number of second contacts 262 is not particularly limited, for example, nine second contacts are provided. When second rear surface 202 is viewed in the plan view, second contacts 262 are arranged along a line. One of second contacts 262 is, for example, a terminal for electric power supply.

Second magnetic connection portion 211 is configured, for example, with a pair of magnets. Second magnetic connection portion 211 is located between second main body portion 283 and second front surface 201. Second magnetic connection portion 211 is arranged inside second device 200. When second rear surface 202 is viewed in the plan view, second electrical connection portion 260 is located as lying between the pair of magnets. Second magnetic connection portion 211 is magnetically attractable to first magnetic connection portion 111 while it is distant from first magnetic connection portion 111.

As shown in Fig. 11, second device 200 includes a second substrate 231 and a second antenna 232. Each of second substrate 231 and second antenna 232 is arranged inside second device 200. More particularly, each of second substrate 231 and second antenna 232 is arranged inside second housing 265. Second antenna 232 is provided at second substrate 231.

The number of second antennas 232 is not particularly limited. The number of second antennas 232 is set, for example, to one or at least two. In electronic device 300 according to the present embodiment, two second antennas 232 are provided. Second antenna 232 may include a second antenna portion 234 and a third antenna portion 236. Second substrate 231 may include a first substrate portion 233 and a second substrate portion 235. Second antenna portion 234 is provided at first substrate portion 233. Third antenna portion 236 is provided at second substrate portion 235. When second rear surface 202 is viewed in the plan view, second connection portion 220 may be arranged as lying between second antenna portion 234 and third antenna portion 236.

As shown in Fig. 11, when second rear surface 202 is viewed in the plan view, second antenna 232 may be located on an outer side of second connection portion 220 in each of directions toward left and right side surfaces. From another point of view, when second rear surface 202 is viewed in the plan view, second antenna 232 may be arranged at a position not superimposed on second main body portion 283. For example, resin is employed as a material for second housing 265. Though the material for second main body portion 283 is not particularly limited, for example, metal may be adopted. Second antenna 232 may be arranged such that second main body portion 283 does not cut off electromagnetic field.

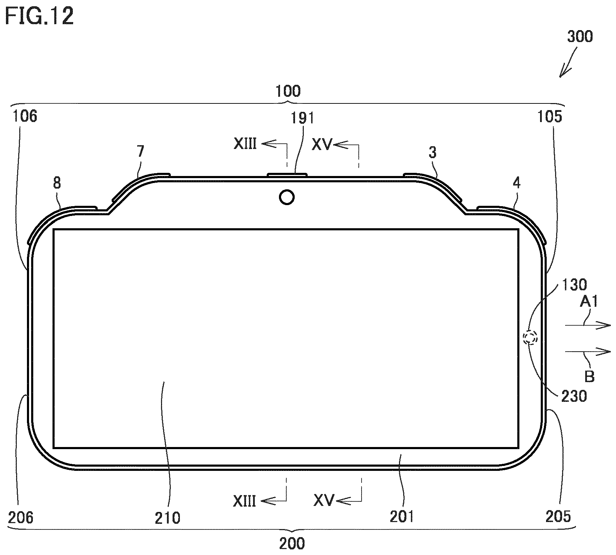

Fig. 12 is a schematic front view showing a configuration of electronic device 300 in a first connection state. In the first connection state, second rear surface 202 is arranged to cover first display 110. Second rear surface 202 may be arranged to cover the entire surface or at least a part of first display 110. Second rear surface 202 is arranged as being superimposed on first front surface 101. Second front surface 201 faces outward. A user can visually recognize second display 210 arranged at second front surface 201. In the first connection state, Hall element 130 is arranged as being superimposed on magnet portion 230. With Hall element 130, the current connection state may be determined as the first connection state.

A direction from first left side surface 106 toward first right side surface 105 of first device 100 corresponds to a reference direction B. In the first connection state, when first display 110 is viewed in the plan view, a direction from second left side surface 206 toward second right side surface 205 of second device 200 is a first direction A1. In the first connection state, first device 100 and second device 200 are connected such that the direction from second left side surface 206 toward second right side surface 205 of second device 200 is the same as reference direction B when first display 110 is viewed in the plan view.

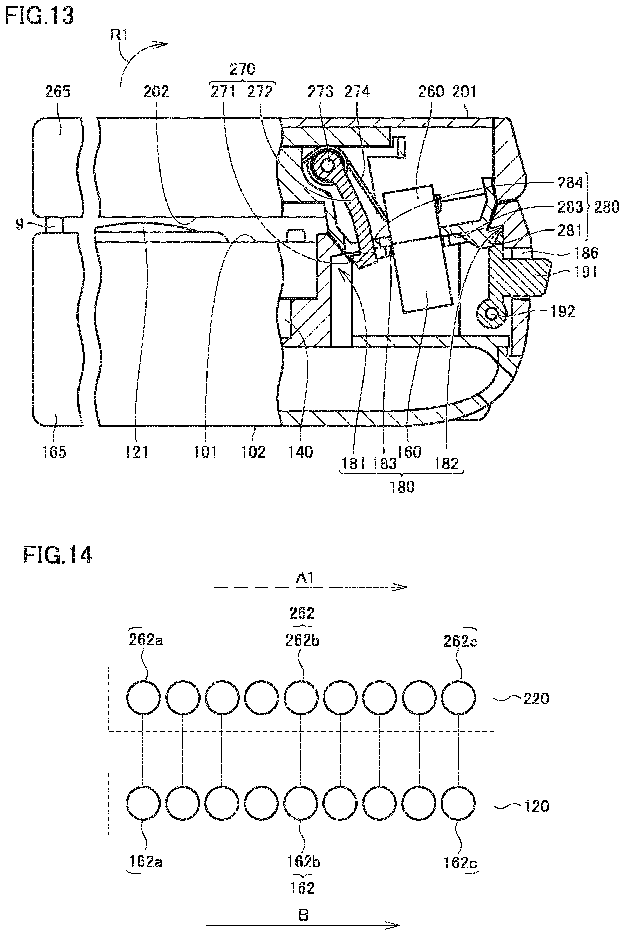

Fig. 13 is a schematic cross-sectional view along the line XIII-XIII in Fig. 12. First connection portion 120 is connected to second connection portion 220. Specifically, first mechanical connection portion 180 is mechanically connected to second mechanical connection portion 280. First mechanical connection portion 180 includes a first receiving groove 181 and a second receiving groove 182. Specifically, each of first receiving groove 181 and second receiving groove 182 is provided at a rear side of first main body portion 183. Second receiving groove 182 is located opposite to first receiving groove 181. First electrical connection portion 160 is located between first receiving groove 181 and second receiving groove 182.

First connection portion 120 is provided with a fourth opening portion 186. Unlocking button 191 is exposed through fourth opening portion 186. First device 100 includes a first rotation shaft 192. Unlocking button 191 is pivotable around first rotation shaft 192. Fixed hook 281 is arranged in second receiving groove 182 provided at the rear side of first main body portion 183. Unlocking button 191 may be in contact with fixed hook 281.

Second device 200 includes a second rotation shaft 273 and a biasing member 274. Movable hook 270 is pivotable around second rotation shaft 273. Movable hook 270 includes a first tab portion 271 and a first support portion 272. First tab portion 271 is contiguous to first support portion 272. First support portion 272 is pivotably attached to second rotation shaft 273. Biasing member 274 biases movable hook 270. Biasing member 274 is, for example, a spring. Each of second rotation shaft 273 and biasing member 274 is arranged inside second device 200. A part of movable hook 270 passes through third opening portion 284.

As shown in Figs. 8 and 11, a width (a second width W2) of movable hook 270 is larger than a width (a first width W1) of a pair of first protruding portions 184. Therefore, in the first connection state, movable hook 270 rides on the pair of first protruding portions 184. In other words, movable hook 270 is not arranged in first receiving groove 181. As shown in Fig. 13, in the first connection state, as fixed hook 281 enters second receiving groove 182, first device 100 and second device 200 are connected. Second device 200 is thus attached to first device 100. In removal of second device 200 from first device 100, second device 200 is turned in a first rotation direction R1. In this case, unlocking button 191 does not have to be pushed.

As shown in Fig. 13, electronic device 300 includes a fourth protruding portion 9. Fourth protruding portion 9 may be attached to first front surface 101 of first device 100 or second rear surface 202 of second device 200. In the first connection state, fourth protruding portion 9 is located between first front surface 101 and second rear surface 202. In the first connection state, first front surface 101 and second rear surface 202 are substantially in parallel to each other. In the first connection state, while second display 210 is in parallel to first display 110, first device 100 and second device 200 may be connected. With fourth protruding portion 9, a gap is provided between first front surface 101 and second rear surface 202. Input portion 121 is distant from second rear surface 202. Fourth protruding portion 9 can prevent first device 100 and second device 200 from wobbling in the first connection state.

As shown in Fig. 13, first electrical connection portion 160 is electrically connected to second electrical connection portion 260. Fig. 14 is a schematic diagram showing relation between the first connection portion and the second connection portion in the first connection state. The first connection state refers to a state in which second connection portion 220 is connected to first connection portion 120 in first direction A1. In the first connection state, first contact 162 is electrically connected to second contact 262.

As shown in Fig. 14, first contact 162 includes a first terminal 162a, a second terminal 162b, and a third terminal 162c. First electrical connection portion 160 may have terminals disposed in the longitudinal direction of first display 110. First terminal 162a is located closest to the first left side surface. Third terminal 162c is located closest to the first right side surface. Second terminal 162b is located intermediate between first terminal 162a and third terminal 162c. A direction from first terminal 162a toward third terminal 162c corresponds to reference direction B.

Second contact 262 includes a fourth terminal 262a, a fifth terminal 262b, and a sixth terminal 262c. Second electrical connection portion 260 may have terminals disposed in the longitudinal direction of second display 210. Fourth terminal 262a is located closest to the second left side surface. Sixth terminal 262c is located closest to the second right side surface. Fifth terminal 262b is located intermediate between fourth terminal 262a and sixth terminal 262c. In the first connection state, first terminal 162a, second terminal 162b, and third terminal 162c are electrically connected to fourth terminal 262a, fifth terminal 262b, and sixth terminal 262c, respectively. In the first connection state, second connection portion 220 is arranged with respect to first connection portion 120 such that a direction from fourth terminal 262a toward sixth terminal 262c is the same as first direction A1. Without being limited to such arrangement of the terminals, first contact 162 and second contact 262 should only be in arrangement relation in which they are connected to each other in the first connection state and the second connection state. For example, a plurality of terminals may be arranged such that, with respect to a terminal arranged at the center, other terminals are in line symmetry.

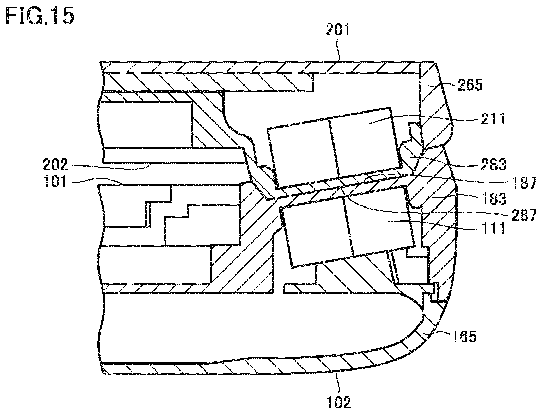

Fig. 15 is a schematic cross-sectional view along the line XV-XV in Fig. 12. As shown in Fig. 15, first magnetic connection portion 111 is arranged inside first main body portion 183. First main body portion 183 includes a first inclined surface 187. First inclined surface 187 is inclined with respect to first front surface 101 of first housing 165. An angle of inclination of first inclined surface 187 with respect to first front surface 101 is, for example, 10°. First magnetic connection portion 111 is arranged along first inclined surface 187. A surface of first magnetic connection portion 111 may substantially be in parallel to first inclined surface 187.

Similarly, second magnetic connection portion 211 is arranged inside second main body portion 283. Second main body portion 283 includes a second inclined surface 287. Second inclined surface 287 is inclined with respect to second rear surface 202 of second housing 265. An angle of inclination of second inclined surface 287 with respect to second rear surface 202 is, for example, 10°. Second magnetic connection portion 211 is arranged along second inclined surface 287. A surface of second magnetic connection portion 211 may substantially be in parallel to second inclined surface 287. The surface of second magnetic connection portion 211 may substantially be in parallel to the surface of first magnetic connection portion 111.

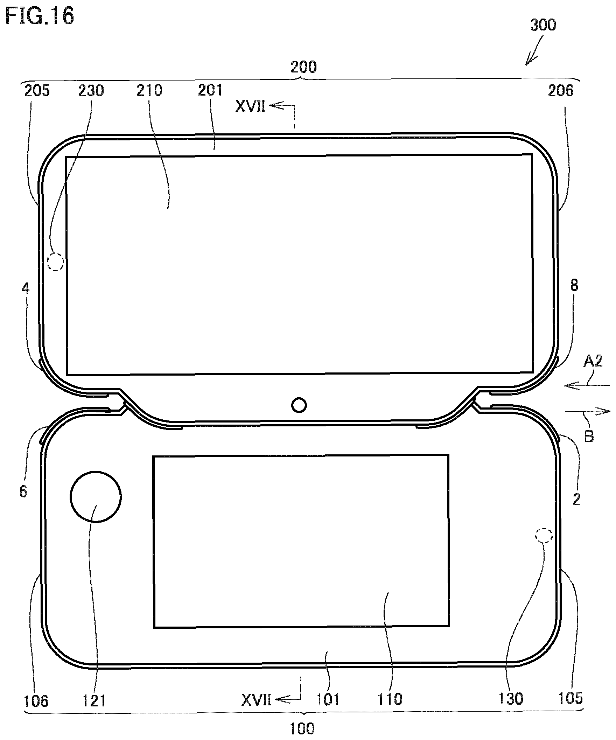

Fig. 16 is a schematic front view showing a configuration of electronic device 300 in the second connection state. In the second connection state, second rear surface 202 is arranged not to cover first display 110. Therefore, the user can visually recognize each of first display 110 and second display 210. In the second connection state, a part of first front surface 101 of first device 100 is arranged as being superimposed on a part of first rear surface 102 of second device 200. In the second connection state, Hall element 130 is arranged as not being superimposed on magnet portion 230. With Hall element 130, the current connection state may be determined as the second connection state.

In the second connection state, when first display 110 is viewed in the plan view, the direction from second left side surface 206 toward second right side surface 205 of second device 200 is a second direction A2. In the second connection state, first device 100 and second device 200 are connected such that the direction from second left side surface 206 toward second right side surface 205 of second device 200 is opposite to reference direction B when first display 110 is viewed in the plan view.

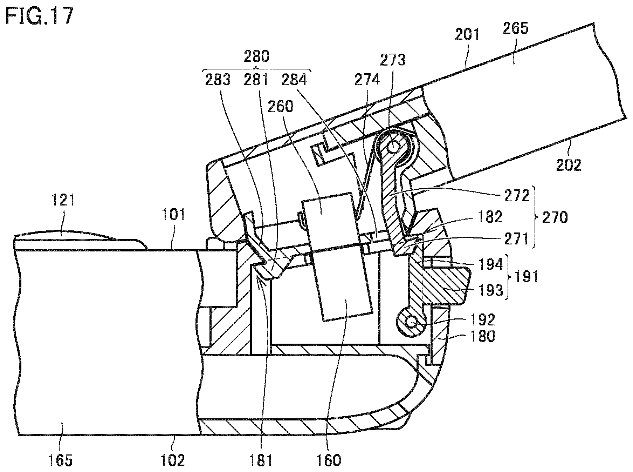

Fig. 17 is a schematic cross-sectional view along the line XVII-XVII in Fig. 16. As shown in Fig. 17, in the second connection state, movable hook 270 is arranged in second receiving groove 182 and fixed hook 281 is arranged in first receiving groove 181. Movable hook 270 has entered second receiving groove 182. Fixed hook 281 has entered first receiving groove 181. First mechanical connection portion 180 is thus mechanically fixed to second mechanical connection portion 280.

As shown in Fig. 17, first electrical connection portion 160 is electrically connected to second electrical connection portion 260. Specifically, in the second connection state, first contact 162 and second contact 262 are connected. Second rear surface 202 is inclined with respect to first front surface 101. In the second connection state, first device 100 and second device 200 may be connected while second display 210 is inclined with respect to first display 110. An angle of inclination of second rear surface 202 with respect to first front surface 101 is, for example, 20°.

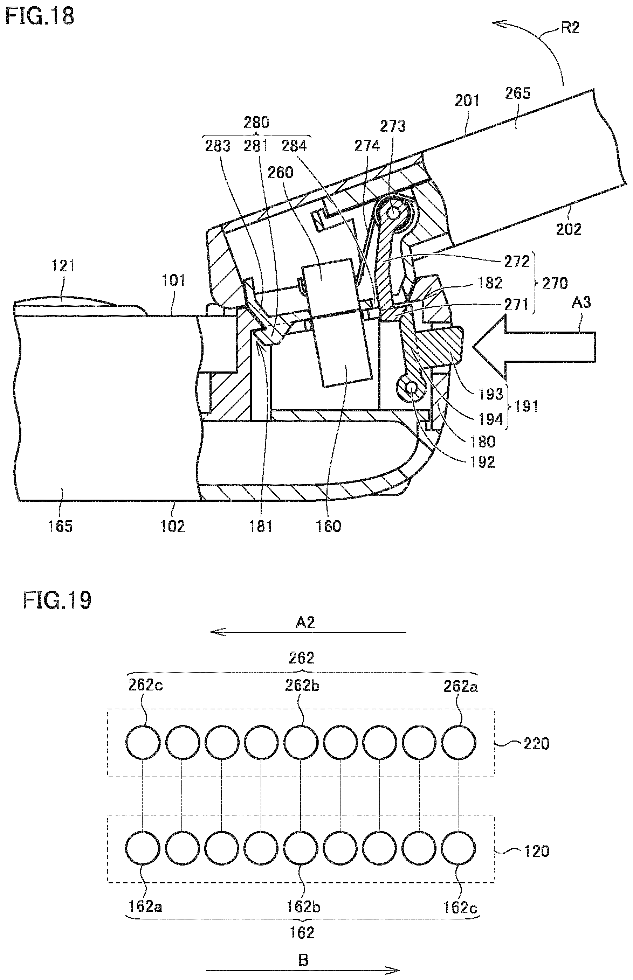

Fig. 18 is a schematic cross-sectional view showing a state in which electronic device 300 in the second connection state is unlocked. As shown in Fig. 18, unlocking button 191 is pushed into first device 100 along a third direction A3. As unlocking button 191 pushes movable hook 270, movable hook 270 is pushed out of second receiving groove 182. Consequently, mechanical locking is released. When second device 200 is turned in second rotation direction R2 in this state, second device 200 is separated from first device 100.

Fig. 19 is a schematic diagram showing relation between the first connection portion and the second connection portion in the second connection state. The second connection state refers to a state in which second connection portion 220 is connected to first connection portion 120 in second direction A2. Second direction A2 is opposite to first direction A1. In the second connection state, first terminal 162a, second terminal 162b, and third terminal 162c are electrically connected to sixth terminal 262c, fifth terminal 262b, and fourth terminal 262a, respectively. In the second connection state, second connection portion 220 is arranged with respect to first connection portion 120 such that the direction from fourth terminal 262a toward sixth terminal 262c is the same as second direction A2.

Each of second terminal 162b and fifth terminal 262b is, for example, a terminal for electric power supply. In each of the first connection state and the second connection state, second terminal 162b is electrically connected to fifth terminal 262b. Usage of first terminal 162a may be the same as usage of third terminal 162c. Similarly, usage of fourth terminal 262a may be the same as usage of sixth terminal 262c. In this case, the same function can be performed in the first connection state and the second connection state. In the first connection state and the second connection state, first contact 162 and second contact 262 may define a plurality of corresponding electrical communication paths. Though usage of first terminal 162a, third terminal 162c, fourth terminal 262a, and sixth terminal 262c is not particularly limited, those terminals may be, for example, terminals for grounding, terminals for determination as to whether or not first device 100 and second device 200 are connected, or terminals for resetting the display.

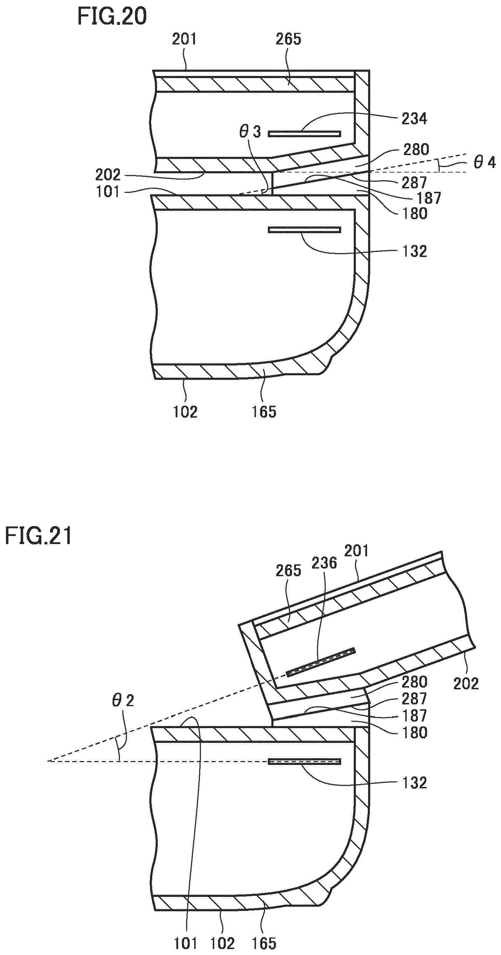

Fig. 20 is a schematic cross-sectional view showing positional relation between first antenna 132 and second antenna 232 in the first connection state. As shown in Fig. 20, in the first connection state, first antenna 132 is arranged as being superimposed on second antenna portion 234 of second antenna 232. In other words, in the first connection state, when first display 110 is viewed in the plan view, first antenna 132 and second antenna 232 are arranged at positions superimposed on each other. Each of first antenna 132 and second antenna 232 is a module in a form of a plate.

As shown in Fig. 20, in a cross-section perpendicular to first front surface 101, first antenna 132 is substantially in parallel to first front surface 101. First antenna 132 is inclined with respect to first inclined surface 187. In a cross-section perpendicular to second rear surface 202, second antenna portion 234 of second antenna 232 is substantially in parallel to second rear surface 202. Second antenna portion 234 of second antenna 232 is inclined with respect to second inclined surface 287. In the first connection state, second antenna portion 234 of second antenna 232 is substantially in parallel to first antenna 132.

In the first connection state, second inclined surface 287 is in contact with first inclined surface 187. An angle between first front surface 101 and first inclined surface 187 in the cross-section perpendicular to first front surface 101 is defined as a third angle θ3. Third angle θ3 is, for example, 10°. An angle between second rear surface 202 and second inclined surface 287 in the cross-section perpendicular to second rear surface 202 is defined as a fourth angle θ4. Fourth angle θ4 is, for example, 10°.

Fig. 21 is a schematic cross-sectional view showing positional relation between first antenna 132 and second antenna 232 in the second connection state. As shown in Fig. 21, in the second connection state, first antenna portion 132 of first antenna 132 is arranged as being superimposed on third antenna portion 236 of second antenna 232. In other words, in the second connection state, when first display 110 is viewed in the plan view, first antenna 132 and second antenna 232 are arranged at positions superimposed on each other. As set forth above, in each of the first connection state and the second connection state, at least a part of first antenna 132 is arranged at a position superimposed on second antenna 232.

As shown in Fig. 21, in the second connection state, third antenna portion 236 of second antenna 232 is inclined with respect to first antenna 132. In the cross-section perpendicular to each of first front surface 101 and second rear surface 202, an angle of inclination (a second angle θ2) of third antenna portion 236 of second antenna 232 with respect to first antenna 132 is, for example, 20°. In the second connection state, second inclined surface 287 is in contact with first inclined surface 187.

Though an example in which first inclined surface 187 and second inclined surface 287 are provided is described with reference to Figs. 20 and 21, first inclined surface 187 does not have to be provided in first mechanical connection portion 180 or second inclined surface 287 does not have to be provided in second mechanical connection portion 280. Specifically, first mechanical connection portion 180 and second mechanical connection portion 280 may be configured to be connected in parallel to each other. In that case, first device 100 and second device 200 may be in parallel to each other, or one of first device 100 or second device 200 may be inclined with respect to the other of first device 100 or second device 200.

Though the configuration in which first antenna 132 includes a single antenna portion and second antenna 232 includes two antenna portions is described above, the present disclosure is not limited to the configuration. In electronic device 300 according to another manner, first antenna 132 may include two antenna portions and second antenna 232 may include a single antenna portion. Specifically, second antenna 232 may include the first antenna portion. First antenna 132 may include the second antenna portion and the third antenna portion. In the first connection state, the first antenna portion may be arranged as being superimposed on the second antenna portion. In the second connection state, the first antenna portion may be arranged as being superimposed on the third antenna portion. In electronic device 300 according to yet another manner, first antenna 132 may include two antenna portions and second antenna 232 may include two antenna portions.

In each of the first connection state and the second connection state, first device 100 and second device 200 can perform first wireless communication through electromagnetic field coupling between first antenna 132 and second antenna 232. When first antenna 132 and second antenna 232 are coupled through electromagnetic field, first device 100 and second device 200 may bidirectionally transmit and receive a signal. Second device 200 may unidirectionally receive a signal transmitted from first device 100. First device 100 may unidirectionally receive a signal transmitted from second device 200. Though each of first antenna 132 and second antenna 232 is not particularly limited, it is, for example, a 60-GHz millimeter wave module.

As shown in Fig. 6, in the first connection state, second rear surface 202 is arranged to cover first display 110. First projecting portion 10 is arranged as being superimposed on second projecting portion 20. Specifically, the front surface of first projecting portion 10 is superimposed on the rear surface of second projecting portion 20. First connection portion 120 provided at the front surface of first projecting portion 10 is connected, in first direction A1, to second connection portion 220 provided at the rear surface of second projecting portion 20.

In the first connection state, in the direction perpendicular to first front surface 101, first operation button 1 and third operation button 3 are arranged as being aligned and second operation button 2 and fourth operation button 4 are arranged as being aligned. From another point of view, along the direction from first front surface 101 toward second rear surface 202, first operation button 1 and third operation button 3 are arranged as being aligned and second operation button 2 and fourth operation button 4 are arranged as being aligned.

In the first connection state, in the direction perpendicular to first front surface 101, fifth operation button 5 and seventh operation button 7 are arranged as being aligned and sixth operation button 6 and eighth operation button 8 are arranged as being aligned. From another point of view, along the direction from first front surface 101 toward second rear surface 202, fifth operation button 5 and seventh operation button 7 are arranged as being aligned and sixth operation button 6 and eighth operation button 8 are arranged as being aligned.

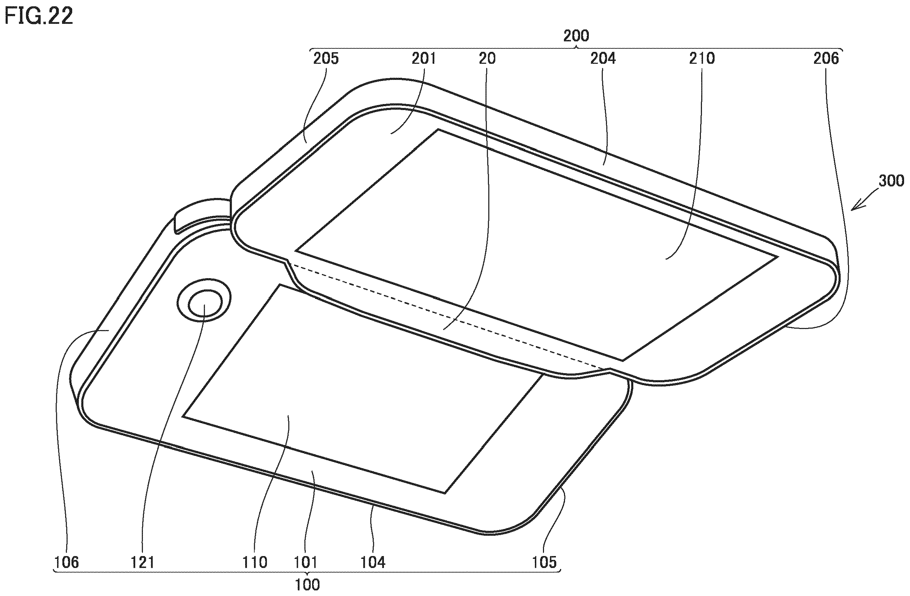

Fig. 22 is a schematic perspective view showing a configuration of electronic device 300 in the second connection state. In the second connection state, second rear surface 202 is arranged not to cover first display 110. First projecting portion 10 is arranged as being superimposed on second projecting portion 20. Specifically, the front surface of first projecting portion 10 is superimposed on the rear surface of second projecting portion 20. First connection portion 120 provided at the front surface of first projecting portion 10 is connected, in second direction A2, to second connection portion 220 provided at the rear surface of second projecting portion 20.

In the second connection state, first device 100 and second device 200 are connected such that first projecting portion 10 is superimposed on second projecting portion 20, and hence first operation button 1, second operation button 2, fifth operation button 5, and sixth operation button 6 are structured to be distant from second device 200. Therefore, when each of first operation button 1, second operation button 2, fifth operation button 5, and sixth operation button 6 is operated, the user's finger is less likely to interfere with third operation button 3, fourth operation button 4, seventh operation button 7, and eighth operation button 8 or second projecting portion 20 of second device 200. Operability of electronic device 300 is thus improved.

First device 100 and second device 200 of electronic device 300 according to the second embodiment are not limited to the configuration above. For example, the configuration of electronic device 300 according to the first embodiment may be applied to first device 100 and second device 200 of electronic device 300 according to the second embodiment. Third operation button 313 of electronic device 300 according to the first embodiment may substantially be the same in configuration to each of first operation button 1, second operation button 2, third operation button 3, fourth operation button 4, fifth operation button 5, sixth operation button 6, seventh operation button 7, and eighth operation button 8 of electronic device 300 according to the second embodiment.

Though the configuration in which second rear surface 202 covers first display 110 in the first connection state and second rear surface 202 covers first display 110 in the second connection state is disclosed, in the first connection state in which second connection portion 220 is connected to first connection portion 120 in first direction A1, second rear surface 202 may be arranged to cover input portion 121, and in the second connection state in which second connection portion 220 is connected to first connection portion 120 in second direction A2, second rear surface 202 may be arranged not to cover input portion 121.

First operation button 1 may be configured to extend to first right upper surface portion 16. Third operation button 3 may be configured to extend to second right upper surface portion 26. Fifth operation button 5 may be configured to extend to first left upper surface portion 17. Seventh operation button 7 may be configured to extend to second left upper surface portion 27.

First operation button 1 and second operation button 2 may integrally be formed. A function as a button may be provided to a portion of each of first operation button 1 and second operation button 2. Third operation button 3 and fourth operation button 4 may integrally be formed. A function as a button may be provided to a portion of each of third operation button 3 and fourth operation button 4. Fifth operation button 5 and sixth operation button 6 may integrally be formed. A function as a button may be provided to a portion of each of fifth operation button 5 and sixth operation button 6. Seventh operation button 7 and eighth operation button 8 may integrally be formed. A function as a button may be provided to a portion of each of seventh operation button 7 and eighth operation button 8.

### (Method of Using Electronic Device)

A method of using electronic device 300 will now be described. Electronic device 300 is, for example, a game console, a smartphone, a tablet personal computer, or the like. First device 100 and second device 200 are usable in both of a case where they are connected to each other and a case where they are separate from each other. As shown in Figs. 12 and 13, in the first connection state, first device 100 and second device 200 are connectable. As shown in Fig. 14, in the first connection state, second connection portion 220 is oriented in first direction A1 with respect to first connection portion 120. As shown in Figs. 16 and 17, in the second connection state, first device 100 and second device 200 are connectable. As shown in Fig. 19, in the second connection state, second connection portion 220 is oriented in second direction A2 with respect to first connection portion 120. In the first connection state and the second connection state, first wireless communication is performed through electromagnetic field coupling between first antenna 132 and second antenna 232.

In the first connection state and the second connection state, first device 100 may transmit an image signal to second device 200 through first antenna 132 and second antenna 232. The image signal is, for example, a scalable low voltage signaling (SLVS) signal. For example, in first device 100, a mobile industry processor interface (MIPI)-display serial interface (DSI) signal is converted to the SLVS signal. The converted SLVS signal is sent from first device 100 to second device 200. In second device 200, the SLVS signal is converted to the MIPI-DSI signal. In another manner, the MIPI-DSI signal may directly be transmitted from first device 100 to second device 200 without being converted to the SLVS signal.

While first device 100 and second device 200 are separate, first device 100 and second device 200 may be able to perform second wireless communication. Second wireless communication while first device 100 and second device 200 are separate may be performed through electromagnetic field coupling between antennas different from each of first antenna 132 and second antenna 232. Specifically, second wireless communication may be, for example, Wifi^{®} communication. A frequency band of a signal to be used in first wireless communication may be higher than a frequency band of a signal to be used in second wireless communication.

Second wireless communication is not limited to Wifi^{®} communication. Second wireless communication may be, for example, communication based on Bluetooth^{®} or infrared communication. Second device 200 may receive a signal from first device 100 and show an image, or second device 200 itself may generate an image without receiving a signal from first device 100.

In the first connection state, the user can play a game in a single-screen mode through first wireless communication. In the second connection state, the user can play a game in a dual-screen mode through first wireless communication. While first device 100 and second device 200 are separate, a first user uses first device 100 and a second user uses second device 200. The first user and the second user can simultaneously play the same game through second wireless communication. In another method of use, one user can operate first device 100 while viewing a screen of second device 200, with the second device being at rest.

At least one of first device 100 and second device 200 that configure electronic device 300 may further include a storage (not shown) and/or a processor (not shown). The storage is, for example, a dynamic random access memory (DRAM) or a nonvolatile memory. An application program such as a game may be stored in the storage. The processor may be able to perform information processing by reading the application program. First display 110 and second display 210 may show an image, for example, generated as a result of information processing performed by the processor. Electronic device 300 may be an information processing apparatus other than the game console.

### (Third Embodiment)

A configuration of electronic device 300 according to a third embodiment will now be described. Electronic device 300 according to the third embodiment is different from electronic device 300 according to the second embodiment mainly in configuration of first mechanical connection portion 180 and second mechanical connection portion 280, and it is otherwise substantially the same as electronic device 300 according to the first second embodiment. A configuration different from that of electronic device 300 according to the second embodiment will mainly be described below.

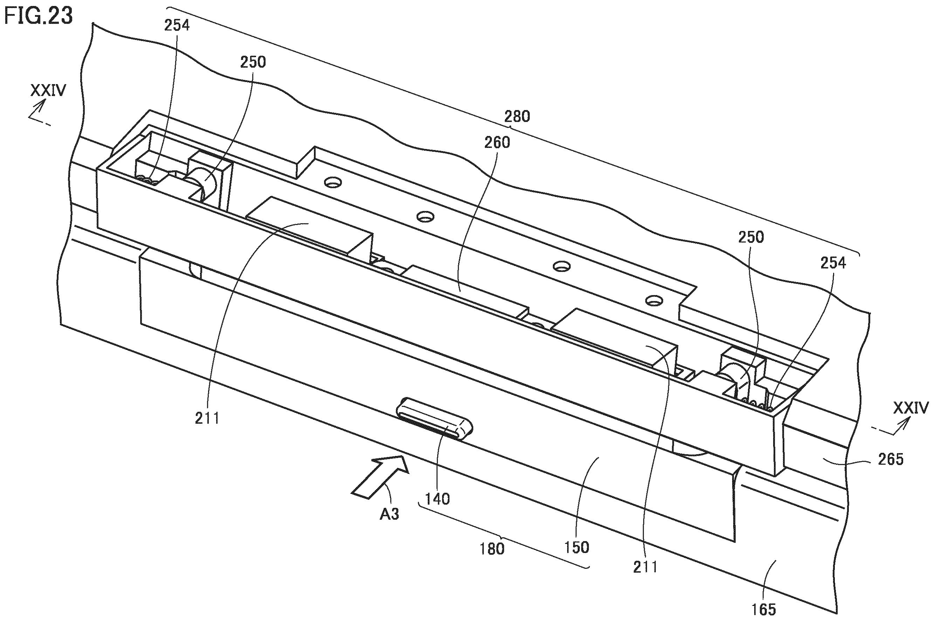

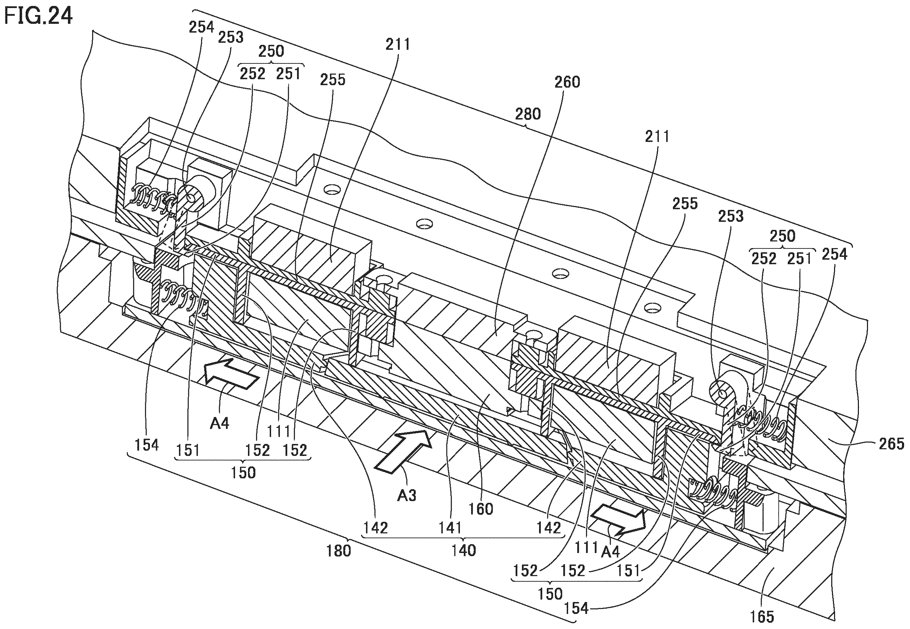

Fig. 23 is a partial schematic perspective view showing the configuration of electronic device 300 according to the third embodiment. Fig. 24 is a schematic cross-sectional view along the line XXIV-XXIV in Fig. 23. As shown in Figs. 23 and 24, first mechanical connection portion 180 includes a movable member 140, a fixed member 150, and a pair of third biasing portions 154. Movable member 140 includes a first plate member 141 and a pair of second plate members 142. When first front surface 101 is viewed in the plan view, first plate member 141 is in a trapezoidal shape. The pair of second plate members 142 is arranged at opposing sides of first plate member 141. The pair of third biasing portions 154 biases the pair of second plate members 142 in a direction toward first plate member 141, respectively.

Fixed member 150 includes an upper surface plate 151 and a partition plate 152. Upper surface plate 151 is arranged above first magnetic connection portion 111. Partition plate 152 is attached to upper surface plate 151. Partition plate 152 extends from upper surface plate 151 toward first rear surface 102. First magnetic connection portion 111 is arranged between the pair of partition plates 152.

Second mechanical connection portion 280 includes a pair of movable hook portions 250, a pair of rotation shaft portions 253, a pair of fourth biasing portions 254, and a lower surface plate 255. The pair of movable hook portions 250 can pivot around the pair of rotation shaft portions 253, respectively. Each of the pair of movable hook portions 250 includes a second tab portion 251 and a second support portion 252. Second tab portion 251 is contiguous to second support portion 252. Second support portion 252 is pivotably attached to rotation shaft portion 253. The pair of fourth biasing portions 254 biases the pair of movable hook portions 250, respectively. Lower surface plate 255 is arranged below second magnetic connection portion 211.

As shown in Fig. 24, when unlocking button 191 is pushed into first device 100 along third direction A3, first plate member 141 pushes the pair of second plate members 142 toward opposing sides. Each of the pair of second plate members 142 moves in a fourth direction A4 perpendicular to third direction A3. The pair of second plate members 142 thus pushes second tab portions 251 of the pair of movable hook portions 250 outward. Consequently, the pair of movable hook portions 250 is unlocked. The pair of unlocked movable hook portions 250 is shown with a dashed line.

As the user releases unlocking button 191, each of the pair of second plate members 142 moves to its original position owing to third biasing portion 154. Each of the pair of movable hook portions 250 moves to its original position owing to fourth biasing portion 254. Second tab portion 251 of each of the pair of movable hook portions 250 moves to a lower side of upper surface plate 151. Consequently, second mechanical connection portion 280 is fixed to first mechanical connection portion 180. The pair of locked movable hook portions 250 is shown with a solid line.

First electrical connection portion 160 may be provided above or below first display 110. First mechanical connection portion 180 is provided to sandwich first electrical connection portion 160 from the longitudinal direction of first display 110. From another point of view, first mechanical connection portion 180 is provided at opposing sides of first electrical connection portion 160.

Second electrical connection portion 260 may be provided above or below second display 210. Second mechanical connection portion 280 is provided to sandwich second electrical connection portion 260 from the longitudinal direction of second display 210. From another point of view, second mechanical connection portion 280 is provided at opposing sides of second electrical connection portion 260. First electrical connection portion 160 is electrically connected to second electrical connection portion 260. First mechanical connection portion 180 is mechanically connected to second mechanical connection portion 280.

In the above, unlocking button 191 is pushed in third direction A3 so that each of the pair of second plate members 142 slides in fourth direction A4 and each of the pair of movable hook portions 250 is unlocked. A locking mechanism is common to the first connection state and the second connection state. Though the configuration in which a slide mechanism releases locking is described above, an unlocking mechanism in the present disclosure is not limited to the slide mechanism. A link mechanism or a gear mechanism may be employed instead of the slide mechanism.

It should be understood that the embodiments disclosed herein are illustrative and non-restrictive in every respect. The scope of the present invention is defined by the terms of the claims rather than the description above and is intended to include any modifications within the scope and meaning equivalent to the terms of the claims.

### REFERENCE SIGNS LIST

1, 311 first operation button; 2, 312 second operation button; 3, 313 third operation button; 4, 314 fourth operation button; 5 fifth operation button; 6 sixth operation button; 7 seventh operation button; 8 eighth operation button; 9 fourth protruding portion; 10 first projecting portion; 11 first central portion; 12 first right inclined portion; 13 first left inclined portion; 14 first front surface portion; 16 first right upper surface portion; 17 first left upper surface portion; 20 second projecting portion; 21 second central portion; 22 second right inclined portion; 23 second left inclined portion; 24 second front surface portion; 26 second right upper surface portion; 27 second left upper surface portion; 29 functional component; 30 opening; 31 touch panel cover; 32 touch panel; 40 support member; 41 shaft receiving portion; 42 hole; 43 detection portion; 44 elastic body; 51 movable shaft; 52 stopper portion; 53 pressed portion; 54 second protruding portion; 55 third protruding portion; 61 first projecting region; 61a fourth central portion; 61b fourth right inclined portion; 61c fourth left inclined portion; 62 second projecting region; 62a fifth central portion; 62b fifth right inclined portion; 62c fifth left inclined portion; 70 fifth opening portion; 81 first tactile feel presentation portion; 82 second tactile feel presentation portion; 100 first device; 101 first front surface; 102 first rear surface; 103 first upper surface; 104 first lower surface; 105 first right side surface; 106 first left side surface; 110 first display; 111 first magnetic connection portion; 120 first connection portion; 121 input portion; 130 Hall element; 131 first substrate; 132 first antenna (first antenna portion); 140 movable member; 141 first plate member; 142 second plate member; 150 fixed member; 151 upper surface plate; 152 partition plate; 154 third biasing portion; 160 first electrical connection portion; 161 first holding portion; 162 first contact; 162a first terminal; 162b second terminal; 162c third terminal; 165 first housing; 180 first mechanical connection portion; 181 first receiving groove; 182 second receiving groove; 183 first main body portion; 184 first protruding portion; 185 first opening portion; 186 fourth opening portion; 187 first inclined surface; 191 unlocking button; 192 first rotation shaft; 200 second device; 201 second front surface; 202 second rear surface; 203 second upper surface; 204 second lower surface; 205 second right side surface; 206 second left side surface; 210 second display; 211 second magnetic connection portion; 220 second connection portion; 230 magnet portion; 231 second substrate; 232 second antenna; 233 first substrate portion; 234 second antenna portion; 235 second substrate portion; 236 third antenna portion; 250 movable hook portion; 251 second tab portion; 252 second support portion; 253 rotation shaft portion; 254 fourth biasing portion; 255 lower surface plate; 260 second electrical connection portion; 261 second holding portion; 262 second contact; 262a fourth terminal; 262b fifth terminal; 262c sixth terminal; 265 second housing; 270 movable hook; 271 first tab portion; 272 first support portion; 273 second rotation shaft; 274 biasing member; 280 second mechanical connection portion; 281 fixed hook; 283 second main body portion; 284 third opening portion; 285 second opening portion; 287 second inclined surface; 300 electronic device; 301 front surface (third front surface); 302 rear surface (third rear surface); 303 upper surface (third upper surface); 304 lower surface (third lower surface); 305 first side surface; 306 second side surface; 310 display (third display); 318 third intermediate upper surface portion; 320 projecting portion (third projecting portion); 321 third central portion; 322 third right inclined portion (first inclined portion); 323 third left inclined portion (second inclined portion); 324 third front surface portion; 326 third right upper surface portion; 327 third left upper surface portion; 365 second housing; A1 first direction; A2 second direction; A3 third direction; A4 fourth direction; B reference direction; H1 first height; H2 second height; L1 first length; L2 second length; R1 first rotation direction; R2 second rotation direction; T thickness; W1 first width; W2 second width; θ2 second angle; θ3 third angle; θ4 fourth angle.

## Claims

1. An electronic device comprising:
a front surface where a display is arranged;
a rear surface located opposite to the front surface;
an upper surface contiguous to the front surface and the rear surface;
a lower surface located opposite to the upper surface;
a first side surface contiguous to each of the front surface, the rear surface, the upper surface, and the lower surface;
a second side surface located opposite to the first side surface,
the upper surface being provided with a projecting portion;
a first operation button arranged at the projecting portion and provided closer to the first side surface relative to a center of the upper surface; and
a second operation button arranged at the upper surface other than the projecting portion and provided closer to the first side surface relative to the first operation button.

2. The electronic device according to claim 1, further comprising:
a third operation button arranged at the projecting portion and provided closer to the second side surface relative to the center of the upper surface; and
a fourth operation button arranged at the upper surface other than the projecting portion and provided closer to the second side surface relative to the third operation button.

3. The electronic device according to claim 2, wherein
the projecting portion comprises
a first inclined portion located at a first side surface side, and
a second inclined portion located at a second side surface side, the first operation button is arranged at the first inclined portion, and
the third operation button is arranged at the second inclined portion.

4. The electronic device according to claim 3, wherein
the projecting portion comprises a central portion located between the first inclined portion and the second inclined portion,
a boundary portion between the central portion and the first inclined portion is curved, and
a boundary portion between the central portion and the second inclined portion is curved.

5. The electronic device according to claim 2, wherein
the second operation button is arranged at a boundary portion between the upper surface and the first side surface, and
the fourth operation button is arranged at a boundary portion between the upper surface and the second side surface.

6. The electronic device according to claim 5, wherein
a boundary portion between the upper surface and the first side surface is curved, and
a boundary portion between the upper surface and the second side surface is curved.

7. The electronic device according to any of claims 2 to 6, wherein in a direction from the lower surface toward the upper surface, a lowermost portion of the first operation button is located above an uppermost portion of the second operation button and a lowermost portion of the third operation button is located above an uppermost portion of the fourth operation button.

8. An electronic device in which a first device and a second device are removably attachable to each other, wherein
the first device comprises
a first front surface where a first display is arranged,
a first rear surface located opposite to the first front surface,
a first upper surface contiguous to the first front surface and the first rear surface,
a first lower surface located opposite to the first upper surface,
a first right side surface contiguous to each of the first front surface, the first rear surface, the first upper surface, and the first lower surface,
a first left side surface located opposite to the first right side surface,
the first upper surface being provided with a first projecting portion,
a first operation button arranged at the first projecting portion and provided closer to the first right side surface relative to a center of the first upper surface, and
a second operation button arranged at the first upper surface other than the first projecting portion and provided closer to the first right side surface relative to the first operation button,
the second device comprises
a second front surface where a second display is arranged,
a second rear surface located opposite to the second front surface,
a second upper surface contiguous to the second front surface and the second rear surface,
a second lower surface located opposite to the second upper surface,
a second right side surface contiguous to each of the second front surface, the second rear surface, the second upper surface, and the second lower surface,
a second left side surface located opposite to the second right side surface,
the second upper surface being provided with a second projecting portion,
a third operation button arranged at the second projecting portion and provided closer to the second right side surface relative to a center of the second upper surface, and
a fourth operation button arranged at the second upper surface other than the second projecting portion and provided closer to the second right side surface relative to the second operation button,
a first connection portion is provided at a first front surface side of the first projecting portion, and
a second connection portion connectable to the first connection portion is provided at a second rear surface side of the second projecting portion.

9. The electronic device according to claim 8, wherein
the second connection portion is connectable to the first connection portion in a first direction and a second direction opposite to the first direction,
in a first connection state in which the second connection portion is connected to the first connection portion in the first direction, the second rear surface is arranged to cover the first display, and
in a second connection state in which the second connection portion is connected to the first connection portion in the second direction, the second rear surface is arranged not to cover the first display.

10. The electronic device according to claim 8 or 9, wherein
the first device further comprises
a fifth operation button arranged at the first projecting portion and provided closer to the first left side surface relative to the center of the first upper surface, and
a sixth operation button arranged at the first upper surface other than the first projecting portion and provided closer to the first left side surface relative to the fifth operation button, and
the second device further comprises
a seventh operation button arranged at the second projecting portion and provided closer to the second left side surface relative to the center of the second upper surface, and
an eighth operation button arranged at the second upper surface other than the second projecting portion and provided closer to the second left side surface relative to the seventh operation button.

11. The electronic device according to claim 10, wherein
the first projecting portion comprises
a first right inclined portion located at a first right side surface side, and
a first left inclined portion located at a first left side surface side,
the first right inclined portion is provided with the first operation button and the first left inclined portion is provided with the fifth operation button,
the second projecting portion comprises
a second right inclined portion located at a second right side surface side, and
a second left inclined portion located at a second left side surface side, and
the second right inclined portion is provided with the third operation button and the second left inclined portion is provided with the seventh operation button.

12. The electronic device according to claim 11, wherein
the first projecting portion comprises a first central portion located between the first right inclined portion and the first left inclined portion,
a boundary portion between the first central portion and the first right inclined portion is curved,
a boundary portion between the first central portion and the first left inclined portion is curved,
the second projecting portion comprises a second central portion located between the second right inclined portion and the second left inclined portion,
a boundary portion between the second central portion and the second right inclined portion is curved, and
a boundary portion between the second central portion and the second left inclined portion is curved.

13. The electronic device according to claim 10, wherein
the second operation button is arranged at a boundary portion between the first upper surface and the first right side surface,
the sixth operation button is arranged at a boundary portion between the first upper surface and the first left side surface,
the fourth operation button is arranged at a boundary portion between the second upper surface and the second right side surface, and
the eighth operation button is arranged at a boundary portion between the second upper surface and the second left side surface.

14. The electronic device according to claim 13, wherein
a boundary portion between the first upper surface and the first right side surface is curved,
a boundary portion between the first upper surface and the first left side surface is curved,
a boundary portion between the second upper surface and the second right side surface is curved, and
a boundary portion between the second upper surface and the second left side surface is curved.

15. The electronic device according to claim 10, wherein
in a direction from the first lower surface toward the first upper surface, a lowermost portion of the first operation button is located above an uppermost portion of the second operation button and a lowermost portion of the fifth operation button is located above an uppermost portion of the sixth operation button, and
in a direction from the second lower surface toward the second upper surface, a lowermost portion of the third operation button is located above an uppermost portion of the fourth operation button and a lowermost portion of the seventh operation button is located above an uppermost portion of the eighth operation button.

16. The electronic device according to claim 8 or 9, wherein
at a second front surface side of the second projecting portion, an input portion or a camera lens is provided.
